# EUROPEAN PATENT APPLICATION

(11) **EP 4 246 177 A1**
(43) Date of publication of application: **20.09.2023**
(21) Application number: 21891694.8
(22) Date of filing: 01.11.2021
(51) Int. Cl.: G01S 7/484, H01S 5/022, H01S 5/042, H01S 5/183

(54) **ILLUMINATION DEVICE AND RANGING DEVICE**

(30) Priority: 13.11.2020 JP 2020189789
(71) Applicant: Sony Semiconductor Solutions Corporation, Atsugi-shi, Kanagawa 243-0014 (JP)
(72) Inventor: KIMURA, Motoi, Atsugi-shi, Kanagawa 243-0014 (JP); KOBAYASHI, Takashi, Atsugi-shi, Kanagawa 243-0014 (JP); OIWA, Tatsuya, Atsugi-shi, Kanagawa 243-0014 (JP); XU, Jialun, Atsugi-shi, Kanagawa 243-0014 (JP)
(74) Representative: D Young & Co LLP
(86) International application number: PCT/JP2021/040219
(87) International publication number: WO 2022/102447

(57) **Abstract**

[Object] To provide an illumination apparatus and a ranging apparatus, the illumination apparatus including a light-emitting element that includes a plurality of light emitter groups, the illumination apparatus being suitable to drive the light emitter for each light emitter group.

[Solving Means] An illumination apparatus according to the present technology includes a light-emitting element and a drive circuit. The light-emitting element includes a plurality of first light emitters, a plurality of second light emitters, a lower electrode that is connected to the plurality of first light emitters and the plurality of second light emitters, a first upper electrode that is connected to each of the plurality of first light emitters, and a second upper electrode that is connected to each of the plurality of second light emitters. The drive circuit determines a first current that flows between the lower electrode and the first upper electrode, and a second current that flows between the lower electrode and the second upper electrode.

## Description

### Technical Field

The present disclosure relates to an illumination apparatus that uses, for example, a surface-emitting semiconductor laser as a light-emitting element, and a ranging apparatus that includes the illumination apparatus.

### Background Art

An approach using time of flight (ToF) of light is a ranging method. In the ToF approach, a distance is measured by measuring the time from light being irradiated onto a target by a light emitter such as a laser to the light reflected off the target returning. In a direct ToF approach, the time from light of a short pulse of a pulse width of, for example, one nanosecond being irradiated to the light returning. On the other hand, in an indirect ToF approach, light that is modulated with a continuous square wave or sinusoidal wave is irradiated, and a change in a phase of the returning light is measured. Here, light of a frequency of, for example, 20 MHz or 100 MHz is used. In any of these cases, a higher modulation rate results in a higher degree of ranging accuracy. Thus, there is a need to include a drive circuit used to drive a light emitter at such a high frequency.

As a method for generally measuring a short distance by the ToF approach, there is a method that includes diffusing, using a diffusion plate, pieces of light emitted by a plurality of light emitters, uniformly irradiating the pieces of diffused light onto an entire measurement-target range (uniform irradiation), and detecting the pieces of irradiated light using a light detector that includes a two-dimensionally divided light-receiving section. As a method for increasing a ranging distance, there is a method that includes making pieces of light emitted by a plurality of light emitters substantially parallel using a collimator lens, and irradiating a light beam onto a measurement target in the form of a spot (spot irradiation). For example, Patent Literature 1 discloses an optical projector that enables uniform irradiation and spot irradiation by adjusting a position of a collimator lens.

### Citation List

### Patent Literature

Patent Literature 1: US Patent Application Laid-open No. 2019/0018137

### Disclosure of Invention

### Technical Problem

Light-emitting elements in the past include an electrode that is shared by all of light emitters of a plurality of light emitters. In this case, all of the light emitters are driven at the same time, and it is difficult to cause only a portion of the plurality of light emitters to emit light.

In view of the circumstances described above, it is an object of the present technology to provide an illumination apparatus and a ranging apparatus, the illumination apparatus including a light-emitting element that includes a plurality of light emitter groups, the illumination apparatus being suitable to drive a light emitter for each light emitter group. Solution to Problem

In order to achieve the object described above, an illumination apparatus according to an embodiment of the present technology includes a light-emitting element and a drive circuit.

The light-emitting element includes a plurality of first light emitters, a plurality of second light emitters, a lower electrode that is connected to the plurality of first light emitters and the plurality of second light emitters, a first upper electrode that is connected to each of the plurality of first light emitters, and a second upper electrode that is connected to each of the plurality of second light emitters.

The drive circuit determines a first current that flows between the lower electrode and the first upper electrode, and a second current that flows between the lower electrode and the second upper electrode.

The drive circuit may include a first drive section that is electrically connected to the first upper electrodes and drives the plurality of first light emitters, and a second drive section that is electrically connected to the second upper electrodes and drives the plurality of second light emitters.

The drive circuit may include a drive section that is connected to the lower electrode and drives the plurality of first light emitters and the plurality of second light emitters.

The light-emitting element may include a first-light-emitter group that includes a plurality of first-light-emitter columns each formed by first light emitters of the plurality of first light emitters being connected to each other using first wiring that is in contact with the first upper electrodes, and a second-light-emitter group that includes a plurality of second-light-emitter columns each formed by second light emitters of the plurality of second light emitters being connected to each other using second wiring that is in contact with the second upper electrodes,
currents respectively flowing through first-light-emitter columns of the plurality of first-light-emitter columns may flow in different directions, and
currents respectively flowing through second-light-emitter columns of the plurality of second-light-emitter columns may flow in different directions.

The first-light-emitter column and the second-light-emitter column may be parallel to each other,
the first-light-emitter column and the second-light-emitter column may be arranged alternately,
the first-light-emitter group may include a certain first-light-emitter column that is included in the plurality of first-light-emitter columns and through which a current flows in a first direction, and another first-light-emitter column that is included in the plurality of first-light-emitter columns and through which a current flows in a second direction that is a direction opposite to the first direction, the other first-light-emitter column being situated next to the certain first-light-emitter column in a state in which the second-light-emitter column is situated between the certain first-light-emitter column and the other first-light-emitter column, and
the second-light-emitter group may include a certain second-light-emitter column that is included in the plurality of second-light-emitter columns and through which a current flows in the first direction, and another second-light-emitter column that is included in the plurality of second-light-emitter columns and through which a current flows in the second direction, the other second-light-emitter column being situated next to the certain second-light-emitter column in a state in which the first-light-emitter column is situated between the certain second-light-emitter column and the other second-light-emitter column.

The plurality of first light emitters and the plurality of second light emitters may be a vertical-cavity surface-emitting laser element.

The illumination apparatus may further include
a first optical member that forms a plurality of pieces of first light and a plurality of pieces of second light into pieces of substantially parallel light, and causes the pieces of substantially parallel light to exit the first optical member, the plurality of pieces of first light being a plurality of pieces of first light respectively emitted by first light emitters of the plurality of first light emitters, the plurality of pieces of second light being a plurality of pieces of second light respectively emitted by second light emitters of the plurality of second light emitters; and
a second optical member that forms a beam shape of at least each of the plurality of pieces of first light or each of the plurality of pieces of second light, and causes the plurality of pieces of first light and the plurality of pieces of second light to exit the second optical member in a state in which a piece of first light of the plurality of pieces of first light and a piece of second light of the plurality of pieces of first light have different beam shapes.

The pieces of first light of the plurality of pieces of first light respectively emitted by the first light emitters of the plurality of first light emitters may be irradiated onto an irradiation target in the form of respective spots, and
the plurality of pieces of second light respectively emitted by the second light emitters of the plurality of second light emitters may be substantially uniformly irradiated onto a specified range on the irradiation target in a state in which a portion of a certain piece of second light of the plurality of pieces of second lights overlaps a portion of another piece of second light of the plurality of pieces of second lights, the other piece of second light being emitted by the second light emitter adjacent to the second light emitter emitting the certain piece of second light.

The first light emitter of the plurality of first light emitters and the second light emitter of the plurality of second light emitters may have different light-emitting areas.

The first light emitter of the plurality of first light emitters may have a smaller area than the second light emitter of the plurality of second light emitters.

The first optical member may be a collimator lens.

The second optical member may be a microlens array.

The microlens array may include two types of lenses of different radiuses of curvature.

The second optical member may be a diffractive optical element.

The diffractive optical element may be a Fresnel lens or a binary lens.

The illumination apparatus may further include a third optical member that is arranged in paths of the plurality of pieces of first light and the plurality of pieces of second light, the third optical member refracting or diffracting the plurality of pieces of first light to increase the number of spots irradiated on the irradiation target, the third optical member refracting or diffracting the plurality of pieces of second light to increase a range in which a certain piece of second light of the plurality of pieces of second lights overlaps another piece of second light of the plurality of pieces of second lights, the other piece of second light being emitted by the second light emitter adjacent to the second light emitter emitting the certain piece of second light.

In order to achieve the object described above, an illumination apparatus according to an embodiment of the present technology includes a light-emitting element, a drive circuit, a first optical member, and a second optical member.

The light-emitting element includes a plurality of first light emitters, a plurality of second light emitters, a lower electrode that is connected to the plurality of first light emitters and the plurality of second light emitters, a first upper electrode that is connected to each of the plurality of first light emitters, and a second upper electrode that is connected to each of the plurality of second light emitters.

The drive circuit determines a first current that flows between the lower electrode and the first upper electrode, and a second current that flows between the lower electrode and the second upper electrode.

The first optical member forms a plurality of pieces of first light and a plurality of pieces of second light into pieces of substantially parallel light, and causes the pieces of substantially parallel light to exit the first optical member, the plurality of pieces of first light being a plurality of pieces of first light respectively emitted by first light emitters of the plurality of first light emitters, the plurality of pieces of second light being a plurality of pieces of second light respectively emitted by second light emitters of the plurality of second light emitters.

The second optical member forms a beam shape of each of the plurality of pieces of second light, and causes the plurality of pieces of second light to exit the second optical member.

In order to achieve the object described above, a ranging apparatus according to an embodiment of the present technology includes an illumination apparatus that emits light to an object; a light-receiving section that detects reception of light reflected off the object; and a ranging section that measures a distance to the object.

The illumination apparatus includes a light-emitting element and a drive circuit.

The light-emitting element includes a plurality of first light emitters, a plurality of second light emitters, a lower electrode that is connected to the plurality of first light emitters and the plurality of second light emitters, a first upper electrode that is connected to each of the plurality of first light emitters, and a second upper electrode that is connected to each of the plurality of second light emitters.

The drive circuit determines a first current that flows between the lower electrode and the first upper electrode, and a second current that flows between the lower electrode and the second upper electrode.

### Brief Description of Drawings

[Fig. 1] Fig. 1 is a schematic cross-sectional view illustrating an example of a schematic configuration of an illumination apparatus according to an embodiment of the present technology.
[Fig. 2] Fig. 2 is a block diagram illustrating an example of a schematic configuration of a ranging apparatus that includes the illumination apparatus.
[Fig. 3] Fig. 3 illustrates an irradiation pattern when the illumination apparatus performs spot irradiation.
[Fig. 4] Fig. 4 illustrates an irradiation pattern when the illumination apparatus performs uniform irradiation.
[Fig. 5] Fig. 5 illustrates an irradiation pattern when the illumination apparatus performs the spot irradiation and the uniform irradiation at the same time.
[Fig. 6] Fig. 6 schematically illustrates an example of a planar configuration of a light-emitting element that is included in the illumination apparatus.
[Fig. 7] Fig. 7 schematically illustrates an example of a shape of each light emitter included in the light-emitting element.
[Fig. 8] Fig. 8 is a schematic cross-sectional view illustrating an example of a configuration of the light emitter included in the light element.
[Fig. 9] Fig. 9 schematically illustrates a relationship in connection between each light emitter included in the light-emitting element and wiring.
[Fig. 10A] Fig. 10A is a schematic plan view illustrating an example of a configuration of a microlens array included in the illumination apparatus.
[Fig. 10B] Fig. 10B schematically illustrates an example of a cross-sectional configuration of the microlens array.
[Fig. 11A] Fig. 11A schematically illustrates a position of the light emitter used to perform spot irradiation with respect to the microlens array.
[Fig. 11B] Fig. 11B schematically illustrates a position of the light emitter used to perform uniform irradiation with respect to the microlens array.
[Fig. 12] Fig. 12 is a diagram used to describe a beam forming function of the illumination apparatus.
[Fig. 13] Fig. 13 illustrates a pattern of irradiation performed by the illumination apparatus onto a target.
[Fig. 14] Fig. 14 illustrates an example of a configuration of a drive circuit included in the illumination apparatus.
[Fig. 15] Fig. 15 illustrates an example of the configuration of the drive circuit included in the illumination apparatus.
[Fig. 16] Fig. 16 illustrates an example of the configuration of the drive circuit included in the illumination apparatus.
[Fig. 17] Fig. 17 illustrates an example of the configuration of the drive circuit included in the illumination apparatus.
[Fig. 18] Fig. 18 illustrates an example of the configuration of the drive circuit included in the illumination apparatus.
[Fig. 19] Fig. 19 is a graph in which a voltage of each node in the drive circuit illustrated in Fig. 18 is given.
[Fig. 20] Fig. 20 is a graph in which a relationship between a power supply voltage and current in the drive circuit illustrated in Fig. 18 is given.
[Fig. 21] Fig. 21 is a graph in which the voltage of each node in the drive circuit illustrated in Fig. 18 is given.
[Fig. 22] Fig. 22 is a graph in which the relationship between a power supply voltage and current in the drive circuit illustrated in Fig. 18 is given.
[Fig. 23] Fig. 23 illustrates an example of the configuration of the drive circuit included in the illumination apparatus.
[Fig. 24] Fig. 24 illustrates an example of the configuration of the drive circuit included in the illumination apparatus.
[Fig. 25] Fig. 25 illustrates an example of the configuration of the drive circuit included in the illumination apparatus.
[Fig. 26] Fig. 26 is a graph in which a voltage of each node in the drive circuit illustrated in Fig. 25 is given.
[Fig. 27] Fig. 27 illustrates an example of the configuration of the drive circuit included in the illumination apparatus.
[Fig. 28] Fig. 28 is a plan view illustrating an example of a wiring pattern of a first light emitter and a second light emitter that are included in the light-emitting element.
[Fig. 29] Fig. 29 is a plan view illustrating an example of the wiring pattern of the first light emitter and second light emitter included in the light-emitting element.
[Fig. 30] Fig. 30 is a plan view of a portion of the configuration in Fig. 29.
[Fig. 31] Fig. 31 schematically illustrates a direction of current that flows through a second-light-emitter column in the wiring pattern illustrated in Fig. 29.
[Fig. 32] Fig. 32 is a plan view illustrating an example of the wiring pattern of the first light emitter and second light emitter included in the light-emitting element.
[Fig. 33] Fig. 33 is a plan view of a portion of the configuration in Fig. 32.
[Fig. 34] Fig. 34 schematically illustrates a direction of current that flows through the second-light-emitter column in the wiring pattern illustrated in Fig. 32.
[Fig. 35] Fig. 35 schematically illustrates an example of a sequence of light emission performed by a general ranging apparatus.
[Fig. 36] Fig. 36 illustrates an example of a sequence of light emission performed by the illumination apparatus according to the embodiment of the present technology.
[Fig. 37] Fig. 37 illustrates an example of the sequence of light emission performed by the illumination apparatus according to the embodiment of the present technology.
[Fig. 38] Fig. 38 illustrates an example of the sequence of light emission performed by the illumination apparatus according to the embodiment of the present technology.
[Fig. 39] Fig. 39 is a diagram used to describe a beam forming function according to a first modification of the present technology.
[Fig. 40A] Fig. 40A is a schematic plan view illustrating an example of a configuration of the microlens array according to a second modification of the present technology.
[Fig. 40B] Fig. 40B schematically illustrates an example of a cross-sectional configuration of the microlens array 12 illustrated in Fig. 40A.
[Fig. 41] Fig. 41 is a diagram used to describe a beam forming function according to the second modification of the present technology.
[Fig. 42] Fig. 42 is a schematic cross-sectional view illustrating an example of a schematic configuration of an illumination apparatus according to a third modification of the present technology.
[Fig. 43] Fig. 43 is a schematic plan view illustrating an example of a configuration of a diffractive optical element illustrated in Fig. 42.
[Fig. 44] Fig. 44 illustrates an example of a planar pattern of a portion, in the diffractive optical element illustrated in Fig. 43, that corresponds to a lens.
[Fig. 45] Fig. 45 illustrates a cross-sectional pattern of the portion being included in the diffractive optical element illustrated in Fig. 43 and corresponding to a lens.
[Fig. 46] Fig. 46 illustrates an irradiation pattern obtained upon performing uniform irradiation onto a target through the diffractive optical element illustrated in Fig. 43.
[Fig. 47] Fig. 47 illustrates another example of the cross-sectional pattern of the portion being included in the diffractive optical element illustrated in Fig. 42 and corresponding to a lens.
[Fig. 48] Fig. 48 illustrates an irradiation pattern obtained upon performing uniform irradiation onto a target through the diffractive optical element illustrated in Fig. 47.
[Fig. 49A] Fig. 49A illustrates another example of the planar pattern of the portion being included in the diffractive optical element illustrated in Fig. 42 and corresponding to a lens.
[Fig. 49B] Fig. 49B is an enlarged view of the planar pattern of the portion being included in the diffractive optical element illustrated in Fig. 42 and corresponding to a lens.
[Fig. 50] Fig. 50 illustrates an irradiation pattern obtained upon performing uniform irradiation onto a target through the diffractive optical element illustrated in Fig. 49.
[Fig. 51] Fig. 51 is a schematic cross-sectional view illustrating an example of a schematic configuration of an illumination apparatus according to a fourth modification of the present technology.
[Fig. 52A] Fig. 52A illustrates an irradiation portion, on a target, onto which light is irradiated by each of the light emitter used to perform spot irradiation and the light emitter used to perform uniform irradiation.
[Fig. 52B] Fig. 52B illustrates an irradiation portion, on a target, onto which light emitted by the light emitter used to perform spot illumination is irradiated through a diffraction grating illustrated in Fig. 51.
[Fig. 53] Fig. 53 is a schematic cross-sectional view illustrating an example of a schematic configuration of an illumination apparatus according to a fifth modification of the present technology.
[Fig. 54] Fig. 54 illustrates an example of a cross-sectional configuration of a light-emitting element in the illumination apparatus illustrated in Fig. 53, and a positional relationship between the light-emitting element and the microlens array.
[Fig. 55] Fig. 55 is a schematic cross-sectional view illustrating another configuration of example of the illumination apparatus illustrated in Fig. 53.
[Fig. 56] Fig. 56 schematically illustrates another example of a cross-sectional configuration of the light-emitting element in a sixth modification according to the present technology.
[Fig. 57] Fig. 57 schematically illustrates another example of the cross-sectional configuration of the light-emitting element in the sixth modification according to the present technology.
[Fig. 58] Fig. 58 schematically illustrates another example of the cross-sectional configuration of the light-emitting element in the sixth modification according to the present technology.

### Mode(s) for Carrying Out the Invention

Embodiments of the present disclosure will be described in detail with reference to the drawings. Specific examples of the present disclosure are described below, and the present disclosure is not limited to the following aspects. Further, the present disclosure is not limited to arrangements and dimensions of respective structural elements illustrated in the figures, and a dimensional ratio of the respective structural elements. Note that the description is made in the following order.
1. Embodiments (Examples of Illumination Apparatus That Includes Microlens Array as Optical Element That Includes Beam Forming Function)
   1-1. Configuration of Illumination Apparatus
   1-2. Method for Driving Illumination Apparatus
   1-3. Wiring Pattern of First Light Emitter and Second Light Emitter
   1-4. Sequence of Light Emission Performed by Illumination Apparatus
   1-5. Configuration of Ranging Apparatus
   1-6. Operations and Effects
2. Modifications
   2-1. First Modification (Another Example of Positional Relationship Between Each Light Emitter and Microlens Array)
   2-2. Second Modification (Another Example of Configuration of Microlens Array)
   2-3. Third Modification (Example of Using Diffractive Optical Element as Optical Element That Includes Beam Forming Function)
   2-4. Fourth Modification (Example of Arranging Grating on Output Side of Collimator Lens)
   2-5. Fifth Modification (Example of Using Back Exit Surface-Emitting Laser as Light-Emitting Element)
   2-6. Sixth Modification (Another Example of Configuration of Light-Emitting Element)

### <1. Embodiments>

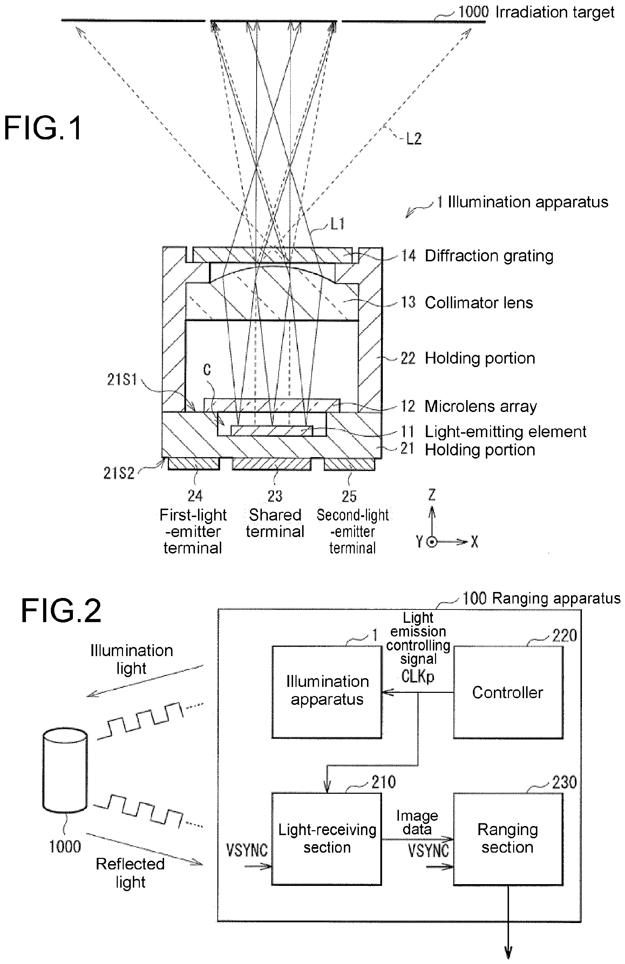

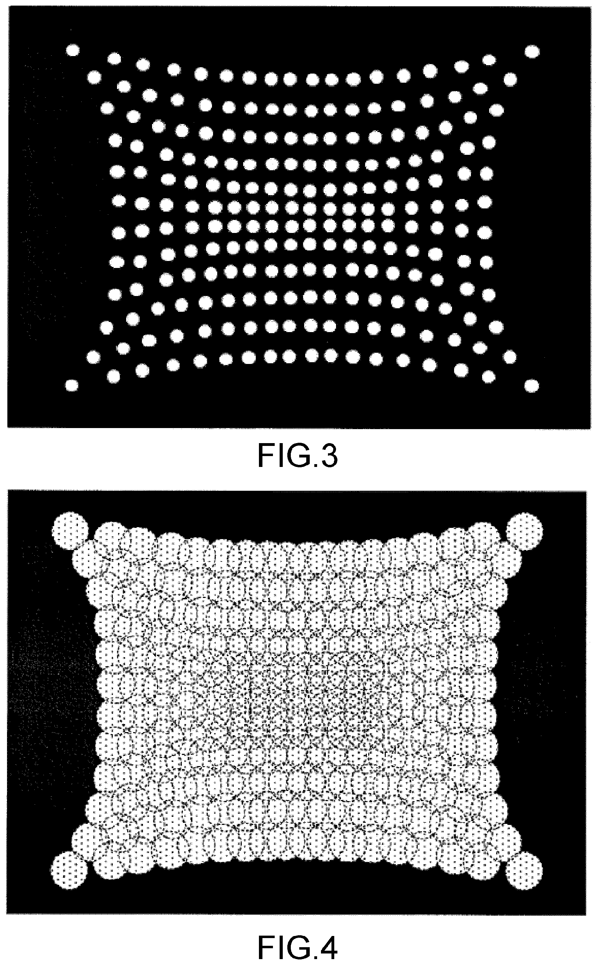

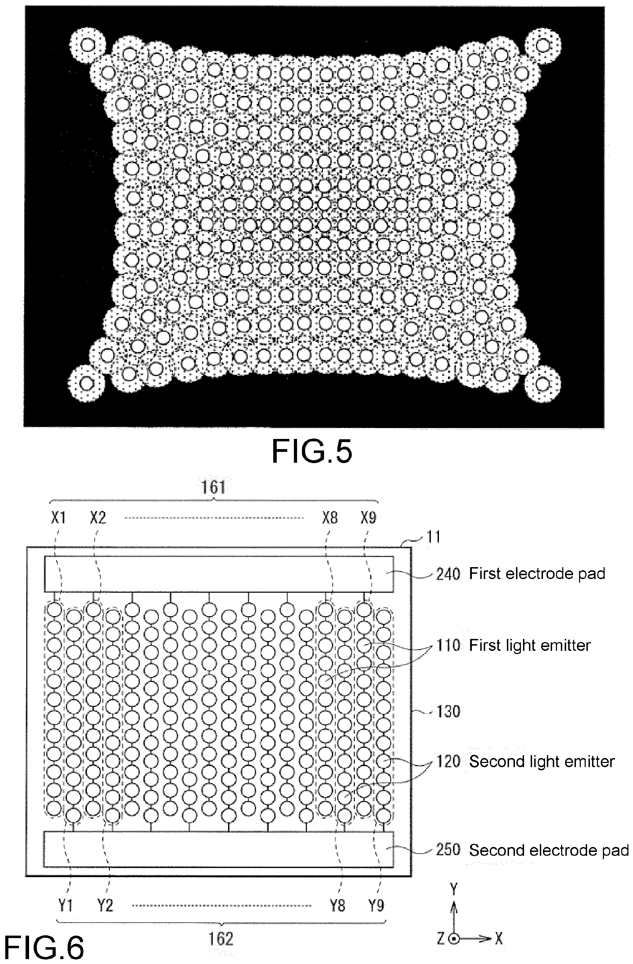

Fig. 1 is a cross-sectional view schematically illustrating an example of a schematic configuration of an illumination apparatus (an illumination apparatus 1) according to an embodiment of the present disclosure. Fig. 2 is a block diagram illustrating a schematic configuration of a ranging apparatus (a ranging apparatus 100) that includes the illumination apparatus 1 illustrated in Fig. 1. The illumination apparatus 1 according to the present embodiment includes a light-emitting element 11. From between light L1 and light L2 that are emitted by the light-emitting element 11, the illumination apparatus 1 forms a beam shape of, for example, the light L2, and performs, for example, spot irradiation onto an irradiation target 1000 as illustrated in Fig. 3, uniform irradiation onto the irradiation target 1000 as illustrated in Fig. 4, and the spot irradiation and the uniform irradiation onto the irradiation target 1000 at the same time as illustrated in Fig. 5.

### (1-1. Configuration of Illumination Apparatus)

The illumination apparatus 1 includes, for example, the light-emitting element 11, a microlens array 12, a collimator lens 13, and a diffractive element 14. The microlens array 12, the collimator lens 13, and the diffractive element 14 are arranged, for example, in this order in paths of pieces of light (the pieces of light L1 and L2) emitted by the light-emitting element 11. The light-emitting element 11 and the microlens array 12 are held by, for example, a holding portion 21, and the collimator lens 13 and the diffractive element 14 are held by, for example, a holding portion 22. For example, the holding portion 21 includes, on a surface 21S2, a shared terminal 23, a first-light-emitter terminal 24, and a second-light-emitter terminal 25, the surface 21S2 being situated opposite to a surface 21S1 on which the light-emitting element 11 and the microlens array 12 are held. Each member of the illumination apparatus 1 is described below in detail.

The light-emitting element 11 includes a plurality of light emitters, and each light emitter is a vertical-cavity surface-emitting laser (VCSEL). The plurality of light emitters includes a plurality of first light emitters 110 used to perform spot irradiation, and a plurality of second light emitters 120 used to perform uniform irradiation. The first light emitter 110 and the second light emitter 120 are electrically isolated from each other, and the first light emitters 110 and the second light emitters 120 are arranged in an array on a substrate 130. In the following description, a light emitter group that includes a plurality of first light emitters 110 is referred to as a first-light-emitter group 161, and a light emitter group that includes a plurality of second light emitters 120 is referred to as a second-light-emitter group 162 (refer to Fig. 6).

The first light emitters 110 of the plurality of first light emitters 110 are electrically connected to each other, and the second light emitters 120 of the plurality of second light emitters 120 are electrically connected to each other. Specifically, the plurality of first light emitters 110 includes a plurality of (for example, nine in Fig. 6) first-light-emitter columns X (first-light-emitter columns X1 to X9) each including n (for example, twelve in Fig. 6) first light emitters 110 that extend in a direction (for example, in a Y-axis direction), as illustrated in, for example, Fig. 6. In other words, a first-light-emitter group 161 includes the plurality of first-light-emitter columns X.

Further, the plurality of second light emitters 120 includes a plurality of (for example, nine in Fig. 6) second-light-emitter columns Y (second-light-emitter columns Y1 to Y9) each including m (for example, twelve in Fig. 6) second light emitters 120 that extend in the direction (for example, in the Y-axis direction). In other words, a second-light-emitter group 162 includes the plurality of second-light-emitter columns Y.

The first-light-emitter column X and the second-light-emitter column Y are alternately arranged on the rectangular substrate 130, as illustrated in, for example, Fig. 6. The first-light-emitter column X is electrically connected to a first electrode pad 240 that is provided along, for example, a certain side of the substrate 130, and the second-light-emitter column Y is electrically connected to a second electrode pad 250 that is provided along, for example, another side of the substrate 130 that faces the certain side.

Note that Fig. 6 illustrates an example of alternately arranging the first-light-emitter column X and the second-light-emitter column Y. However, the configuration is not limited thereto. For example, with respect to each of the number of first light emitters 110 and the number of second light emitters 120, any arrangement may be adopted according to a desired number of light-emitting points, a desired position of the light-emitting point, and a desired amount of optical output of the light-emitting point.

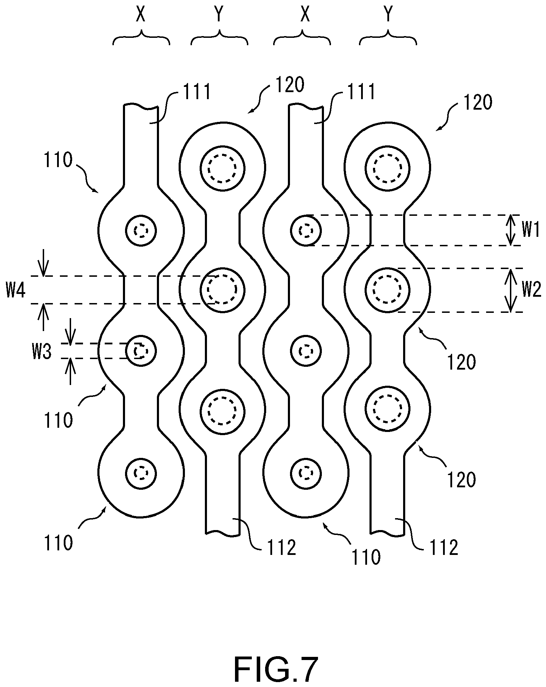

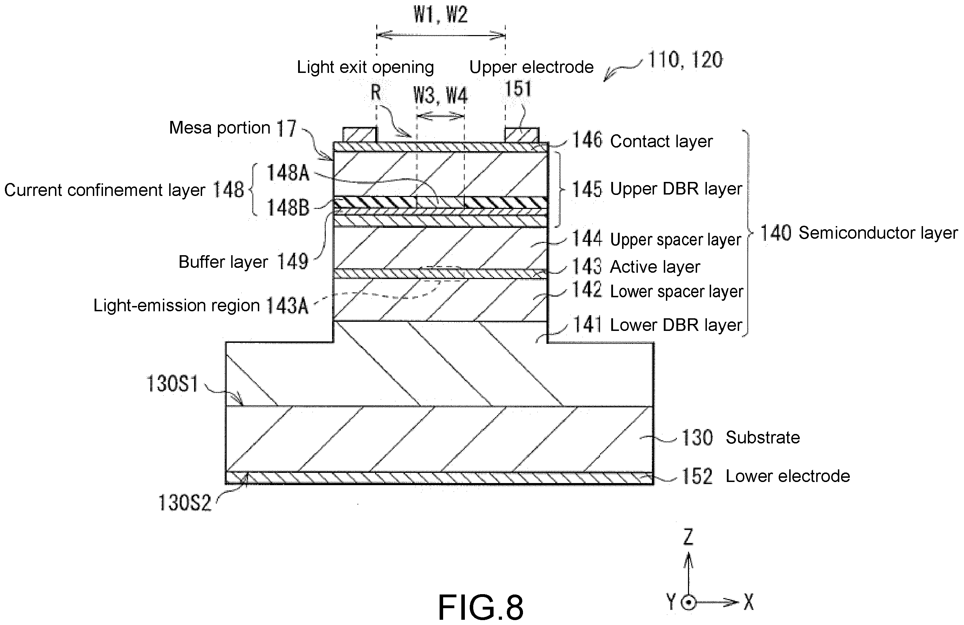

Fig. 7 illustrates an enlarged portion of arrangement of the first-light-emitter column X and the second-light-emitter column Y that is illustrated in Fig. 6. As illustrated in the figure, the first-light-emitter column X is formed by the first light emitters 110 of a plurality of first light emitters 110 being connected to each other using first wiring 111. The first wiring 111 is in contact with an upper electrode 151 (refer to Fig. 8) included in the first light emitter 110 to be electrically connected to the first light emitter 110. Further, the second-light-emitter column Y is formed by the second light emitters 120 of a plurality of second light emitters 120 being connected to each other using second wiring 112. The second wiring 112 is in contact with the upper electrode 151 (refer to Fig. 8) included in the second light emitter 120 to be electrically connected to the second light emitter 120.

It is favorable that the first light emitter 110 and the second light emitter 120 have different light-emitting areas (OA diameters W3 and W4). Specifically, it is favorable that the first light emitter 110 used to perform spot irradiation have a light-emitting area (the OA diameter W3) that is smaller than a light-emitting area (the OA diameter W4) of the second light emitter 120 used to perform uniform irradiation.

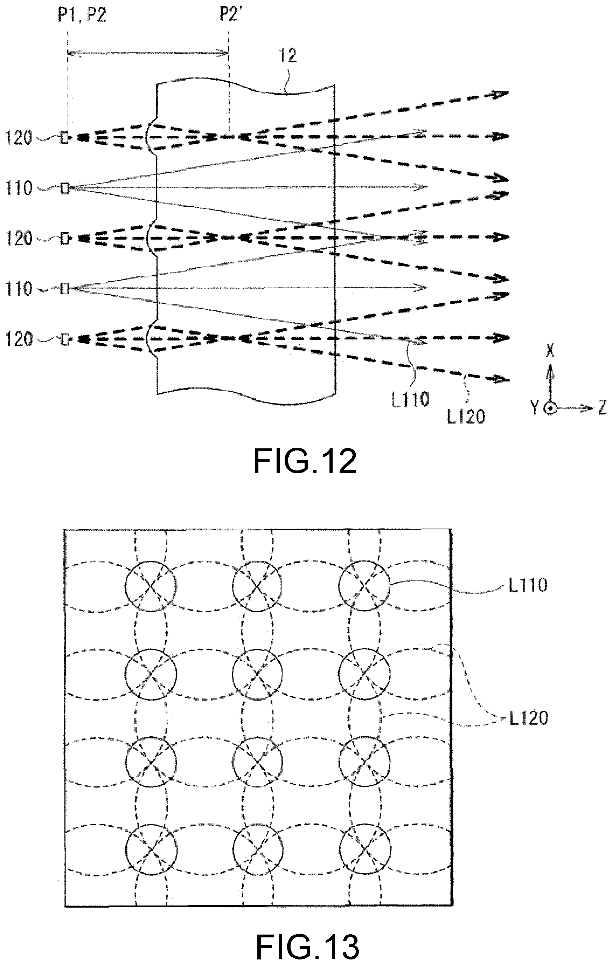

Consequently, a light beam (a laser beam L110, refer to Fig. 13) that is used to perform spot irradiation and irradiated by the first light emitter 110 is concentrated into a smaller spot, and this enables the light beam used to perform spot irradiation to be irradiated onto a target in the form of a smaller spot. Further, a light beam (a laser beam L120, refer to Fig. 13) that is used to perform uniform irradiation and irradiated by the second light emitter 120 can be irradiated onto a larger range, and this enables the light beam used to perform uniform irradiation to be more uniformly irradiated onto the irradiation target 1000 with a higher output. Furthermore, consequently, an opening of the wiring connecting the respective first light emitters 110 has a width W1 smaller than a width W2 of an opening of the wiring connecting the respective second light emitters 120.

Fig. 8 schematically illustrates an example of a configuration of a cross section of the light emitter (the first light emitter 110 and the second light emitter 120) included in the light-emitting element 11. The light-emitting element 11 is a front exit vertical-cavity surface-emitting laser. On a side of a certain surface (a front surface (a surface 130S1)) of the substrate 130, the first light emitter 110 and the second light emitter 120 each include a semiconductor layer 140 that includes a lower DBR layer 141, a lower spacer layer 142, an active layer 143, an upper spacer layer 144, an upper DBR layer 145, and a contact layer 146 in this order. An upper portion of the semiconductor layer 140 that specifically includes a portion of the lower DBR layer 141, the lower spacer layer 142, the active layer 143, the upper spacer layer 144, the upper DBR layer 145, and the contact layer 146 is a pillar-shaped mesa portion 147.

The substrate 130 is, for example, an n-type GaAs substrate. Examples of n-type impurities include silicon (Si) and selenium (Se). The semiconductor layer 140 includes, for example, an AlGaAs-based compound semiconductor. The AlGaAs-based compound semiconductor refers to a compound semiconductor that includes at least aluminum (Al) and gallium (Ga) from among Group III-B elements in a short-form periodic table, and at least arsenic (As) from among Group V-B elements in the short-form periodic table.

The lower distributed Bragg reflector (DBR) layer 141 is formed by alternately stacking a low-refractive-index layer and a high-refractive-index layer (neither of them is illustrated). The low-refractive-index layer is made of, for example, n-type Alₓ₋₁Ga₁₋ₓ₁As having a thickness of λ₀/4ₙ₁ (0<x1<1) (λ represents an emission wavelength and n1 represents a refractive index). The high-refractive-index layer is made of, for example, n-type Alₓ₋₂Ga₁₋ₓ₂As having a thickness of λ₀/4ₙ₂ (0<x2<x1) (n2 represents a refractive index).

The lower spacer layer 142 is made of, for example, n-type Alₓ₋₃Ga₁₋ₓ₃As (0<x3<1). The active layer 143 is made of, for example, undoped n-type Alₓ₋₄Ga₁₋ₓ₄As (0<x4<1). The upper spacer layer 144 is made of, for example, p-type Alₓ₋₅Ga₁₋ₓ₅As (0<x5<1). Examples of p-type impurities include zinc (Zn), magnesium (Mg), and beryllium (Be).

The upper distributed Bragg reflector (DBR) layer 145 is formed by alternately stacking a low-refractive-index layer and a high-refractive-index layer (neither of them is illustrated). The low-refractive-index layer is made of, for example, p-type Alₓ₆Ga₁₋ₓ₆As having a thickness of λ₀/4ₙ₃ (0<x6<1) (n3 represents a refractive index). The high-refractive-index layer is made of, for example, p-type Alₓ₇Ga₁₋ₓ₇As having a thickness of λ₀/4ₙ₄ (0<x7<x6) (n4 represents a refractive index). The contact layer 16 is made of, for example, p-type Alₓ₈Ga₁₋ₓ₈As (0<x8<1).

The light-emitting element 11 is further provided with a current confinement layer 148 and a buffer layer 149. The current confinement layer 148 and the buffer layer 149 are provided inside of the upper DBR layer 145.

The current confinement layer 148 is formed farther away from the active layer 143 than the buffer layer 149. For example, instead of a low-refractive-index layer, the current confinement layer 148 is provided to a portion, in the upper DBR layer 145, that corresponds to the low-refractive-index layer and is situated away from the active layer 143 by, for example, a few layers. The current confinement layer 148 includes a current injection region 148A and a current confinement region 148B. The current injection region 148A is formed in a center region on a surface of the current confinement layer 148, and corresponds to the above-described light-emitting area (the OA diameter W3, W4) of the first light emitter 110, 120. The current confinement region 148B has an annular shape and is formed at a peripheral edge of the current injection region 148A, that is, in an outer-edge region of the current confinement layer 148.

The current injection region 148A is made of, for example, p-type Alₓ₉Ga₁₋ₓ₉As (0.98≤x9≤1). The current confinement region 148B includes, for example, aluminum oxide (Al₂O₃), and is obtained by, for example, oxidizing an oxidization-target layer (not illustrated) made of p-type Alₓ₉Ga₁₋ₓ₉As from a direction of a lateral surface of the mesa portion 17. Consequently, the current confinement layer 148 serves to confine current.

The buffer layer 149 is formed closer to the active layer 143 than the current confinement layer 148. The buffer layer 149 is formed to be adjacent to the current confinement layer 148. The buffer layer 149 is formed in contact with a surface (a lower surface) of the current confinement layer 148 that is situated on a side of the active layer 143, as illustrated in, for example, Fig. 8. Note that a thin layer having a thickness of, for example, about a few nanometers may be provided between the current confinement layer 148 and the buffer layer 149. For example, instead of a high-refractive-index layer, the buffer layer 149 is provided to a portion, in the upper DBR layer 145, that corresponds to a high-refractive-index layer and is situated away from the current confinement layer 148 by, for example, a few layers.

The buffer layer 149 includes an unoxidized region and an oxidized region (neither of them is illustrated). The unoxidized region is primarily formed on a center region on a surface of the buffer layer 149, and is formed in, for example, a portion that is in contact with the current injection region 148A. The oxidized region has an annular shape and is formed at a peripheral edge of the unoxidized region 19A. The oxidized region is primarily formed in an outer-edge region on the surface of the buffer layer 149, and is formed in, for example, a portion that is in contact with the current confinement region 148B. A portion of the oxidized region that is other than a portion corresponding to the outer edge of the buffer layer 149, is formed closer to the current confinement layer 148.

The unoxidized region is made of a semiconductor material including Al, and is made of, for example, p-type Alₓ₁₀Ga₁₋ₓ₁₀As (0.85<x10≤0.98) or p-type InAlₓ₁₁GaAs (0.85<x11≤0.98). The oxidized region includes, for example, aluminum oxide (Al₂O₃), and is obtained by oxidizing an oxidization-target layer (not illustrated) made of, for example, p-type Alₓ₁₀Ga₁₋ₓ₁₀As or p-type InAlₓ₁₁GaAs from the direction of the lateral surface of the mesa portion 147 and a direction of the oxidization-target layer. A material and a thickness of the oxidization-target layer of the buffer layer 149 result in the oxidization-target layer of the buffer layer 149 being oxidized faster than the lower DBR layer 141 and the upper DBR layer 145 and slower than an oxidization-target layer of the current confinement layer 148.

On an upper surface of the mesa portion 147 (an upper surface of the contact layer 146), an annular upper electrode 151 that includes an opening (a light exit opening R) in at least a region that faces the current injection region 148A. Further, an insulation layer (not illustrated) is formed on the lateral surface of the mesa portion 147 and on a surface around the mesa portion 147.

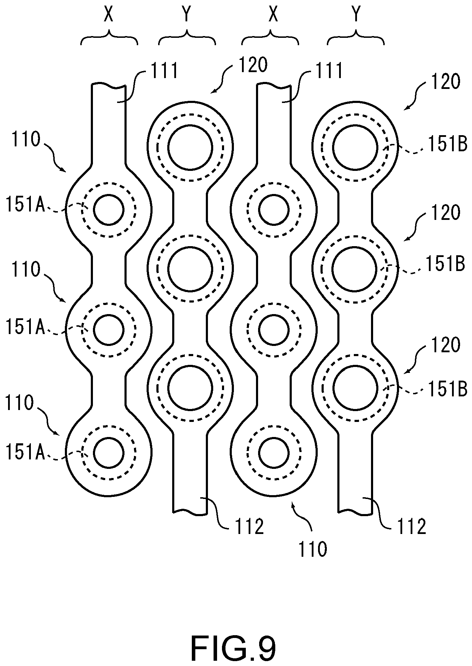

The upper electrode 151 is connected to the first wiring 111 or the second wiring 112 described above. Fig. 9 schematically illustrates the upper electrode 151, the first wiring 111, and the second wiring 112. As illustrated in the figure, the upper electrode 151 included in the first light emitter 110 is referred to as a first upper electrode 151A, and the upper electrode 151 included in the second light emitter 120 is referred to as a second upper electrode 151B. The first upper electrode 151A is in contact with the first wiring 111 to be electrically connected to the first electrode pad 240 through the first wiring 111. Further, the second upper electrode 151B is in contact with the second wiring 112 to be electrically connected to the second electrode pad 250 through the second wiring 112.

The first electrode pad 240 is electrically connected to the first-light-emitter terminal 24 provided on a back surface (the surface 21S2) of the holding portion 21, and the second electrode pad 250 is electrically connected to the second-light-emitter terminal 25 provided on the back surface (the surface 21S2) of the holding portion 21 (refer to Fig. 1).

A lower electrode 152 is provided on another surface (a back surface (a surface 130S2) of the substrate 130. The lower electrode 152 is uniformly provided on a back surface of each of the first light emitter 110 and the second light emitter 120. The lower electrode 152 is electrically connected to each of the first light emitter 110 and the second light emitter 120, and is electrically connected to the shared terminal 23 provided on the back surface (the surface 21S2) of the holding portion 21.

Thus, the first light emitter 110 is electrically connected to the shared terminal 23 and to the first-light-emitter terminal 24, and the second light emitter 120 is electrically connected to the shared terminal 23 and to the second-light-emitter terminal 25. For example, the shared terminal 23 is a cathode of each of the first light emitter 110 and the second light emitter 120, the first-light-emitter terminal 24 is an anode of the first light emitter 110, and the second-light-emitter terminal 25 is an anode of the second light emitter 120. Further, the shared terminal 23 may be an anode of each of the first light emitter 110 and the second light emitter 120, the first-light-emitter terminal 24 may be a cathode of the first light emitter 110, and the second-light-emitter terminal 25 may be a cathode of the second light emitter 120.

The upper electrode 151, the first electrode pad 240, and the second electrode pad 250 are each formed by stacking, for example, titanium (Ti), platinum (Pt), and gold (Au) in this order, and are each electrically connected to the contact layer 146 situated on a top of the mesa portion 147. The lower electrode 152 has a structure in which, for example, an alloy of gold (Au) and germanium (Ge), nickel (Ni), and gold (Au) are stacked in this order from a side of the substrate 130, and is electrically connected to the substrate 130.

The light-emitting element 11 has the configuration described above. Note that the example in which the n-type portion is situated on a side of the lower DBR layer 141, and the p-type portion is situated on a side of the upper DBR layer 145 has been described above, but the positions of the conduction-type portions may be reversed. In other words, the p-type portion may be situated on the side of the lower DBR layer 141, and the n-type portion may be situated on the side of the upper DBR layer 145.

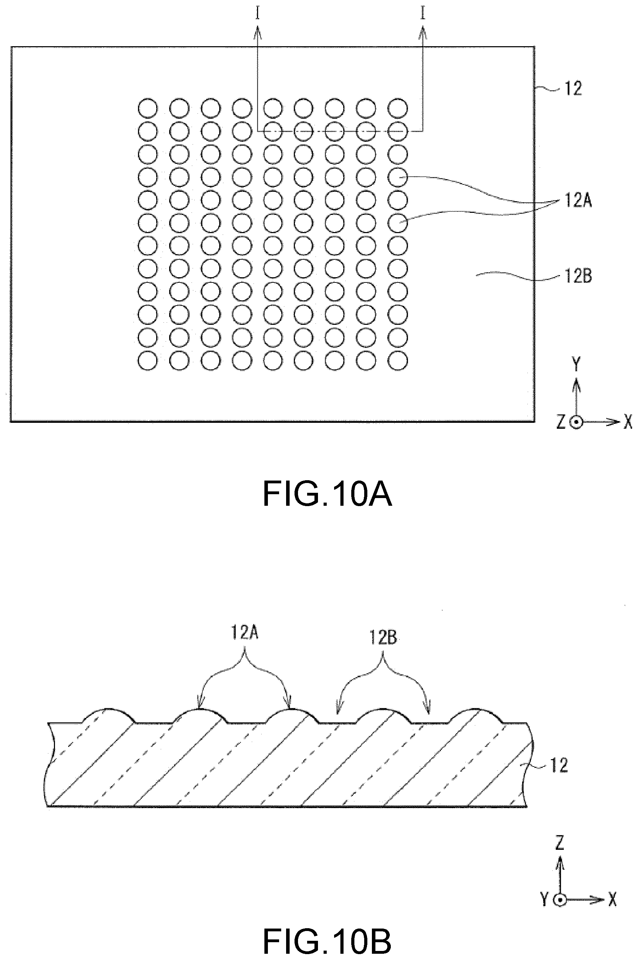

From between pieces of light (the laser beam L110 and the laser beam L120) emitted by the first light emitter 110 and the second light emitter 120, the microlens array 12 (refer to Fig. 1) forms a beam shape of at least one of the pieces of light, and causes the pieces of light to exit the microlens array 12. The microlens array 12 corresponds a specific example of a "second optical member" of the present disclosure. Fig. 10A schematically illustrates an example of a planar configuration of the microlens array 12, and Fig. 10B schematically illustrates a configuration of a cross section of the microlens array 12 along the line I-I illustrated in Fig. 10A. The microlens array 12 is formed by a plurality of microlenses being arranged in an array, and includes a plurality of lens portions 12A and a parallel flat plate portion 12B.

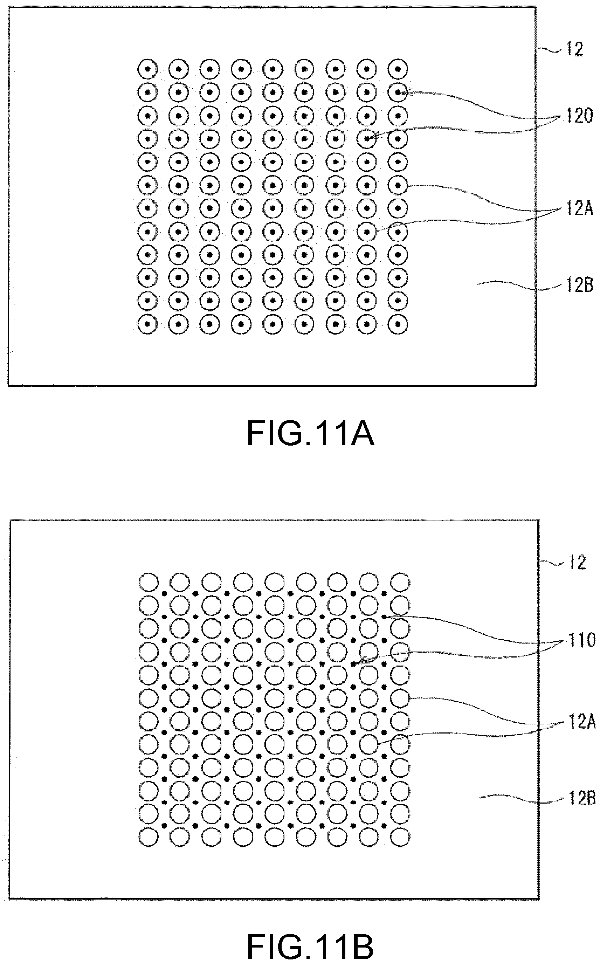

In the present embodiment, the microlens array 12 is arranged such that the lens portion 12A faces the second light emitter 120, as illustrated in Fig. 11A, and such that the parallel flat plate portion 12B faces the first light emitter 110, as illustrated in Fig. 11B. Consequently, the laser beam L120 emitted by the second light emitter 120 is refracted by a lens surface of the lens portion 12A to form, for example, a virtual light-emitting point P2' in the microlens array 12, as illustrated in Fig. 12. In other words, a light-emitting point P2 of the second light emitter 120 that is situated at the same level as a light-emitting point P1 of the first light emitter 110 is shifted in a direction (for example, a Z-axis direction) of an optical axis corresponding to pieces of light (the laser beam L110 and laser beam L120) respectively emitted by the first light emitter 110 and the second light emitter 120.

Thus, when switching is performed between light emission performed by the first light emitter 110 and light emission performed by the second light emitter 120, this results in an irradiation pattern including spots, as illustrated in, for example, Figs. 3 and 13 being formed with the laser beam L110 emitted by the first light emitter 110. Further, when a portion of a certain laser beam L120 emitted by the second light emitter 120 overlaps, for example, a portion of another laser beam L120 emitted by the second light emitter 120 adjacent to the second light emitter 120 emitting the certain laser beam L120, as illustrated in Figs. 4 and 13, this results in forming an irradiation pattern in which irradiation is performed onto a specified range with a substantially uniform degree of intensity of light. The switching between light emission performed by the first light emitter 110 and light emission performed by the second light emitter 120 enables the illumination apparatus 1 to switch spot irradiation and uniform irradiation.

Note that Fig. 12 illustrates an example in which the microlens array 12 serves as a relay lens, but the configuration is not limited thereto. For example, the virtual light-emitting point P2' of the second light emitter 120 may be formed between the second light emitter 120 and the microlens array 12.

The collimator lens 13 forms, into pieces of substantially parallel light, the laser beam L110 emitted by the first light emitter 110 and the laser beam L120 emitted by the second light emitter 120, and causes the pieces of substantially parallel light to exit the collimator lens 13. The collimator lens 13 corresponds to a specific example of a "first optical member" of the present disclosure. For example, the collimator lens 13 is a lens used to individually collimate the laser beam L110 and laser beam L120 exiting the microlens array 12 and to couple the collimated laser beams to the diffractive element 14.

The diffractive element 14 splits each of the laser beam L110 emitted by the first light emitter 110 and the laser beam L120 emitted by the second light emitter 120, and causes laser beams obtained by the split to exit the diffractive element 14. For example, a diffractive optical element (DOE) that splits each of the laser beam L110 emitted by the first light emitter 110 and the laser beam L120 emitted by the second light emitter 120 into three laser beams × three laser beams may be used as the diffractive element 14. The arrangement of the diffractive element 14 makes it possible to perform tiling with respect to respective luminous fluxes of the laser beam L110 and the laser beam L120, and thus to, for example, increase the number of spots upon performing spot irradiation and make an irradiation range adopted upon performing uniform irradiation larger.

The holding portion 21 and the holding portion 22 (refer to Fig. 1) are used to hold the light-emitting element 11, the microlens array 12, the collimator lens 13, and the diffractive element 14. Specifically, the holding portion 21 holds the light-emitting element 11 in a concave portion C that is provided to an upper surface (the surface 21S1) of the holding portion 21, and holds the microlens array 12 along the surface 21S1. The holding portion 22 holds the collimator lens 13 and the diffractive element 14. The microlens array 12 is held by the holding portion 21 using, for example, an adhesive, and the collimator lens 13 and the diffractive element 14 are held by the holding portion 22 using, for example, the adhesive. The holding portion 21 and the holding portion 22 are connected to each other such that the light L1 (specifically, the laser beam L110) and the light L2 (specifically, the laser beam L120) that are emitted by the light-emitting element 11 are each incident on a specified portion of the microlens array 12 and such that the light L1, L2 transmitted through the collimator lens 13 is formed into substantially parallel light.

Note that Fig. 1 illustrates an example in which the microlens array 12 is held by the holding portion 21. Without being limited thereto, the microlens array 12 may be held by, for example, the holding portion 22. Further, the collimator lens 13 and the diffractive element 14 may be held by the holding portion 21.

### (1-2. Method for Driving Illumination Apparatus)

In the illumination apparatus 1 of the present embodiment, the first light emitter 110 and the second light emitter 120 that are provided to the light-emitting element 11 are driven independently of each other. In the illumination apparatus 1, switching between light emission performed by the first light emitter 110 and light emission performed by the second light emitter 120 is performed, and this makes it possible to perform spot irradiation and uniform irradiation onto the target 1000 in a single apparatus, the spot irradiation being irradiating light beams (the laser beams L110) onto the target 1000 in the form of spots independent of each other, the uniform irradiation being irradiating a light beam (the laser beam L120) onto the target 1000 in which irradiation is performed onto a specified range with a substantially uniform degree of intensity of light. Specifically, the illumination apparatus 1 may include a drive circuit that can determine current that flows through the first light emitter 110 and current that flows through the second light emitter 120. Various drive circuits of the illumination apparatus 1 are described below.

### [Switching Performed Using Switch]

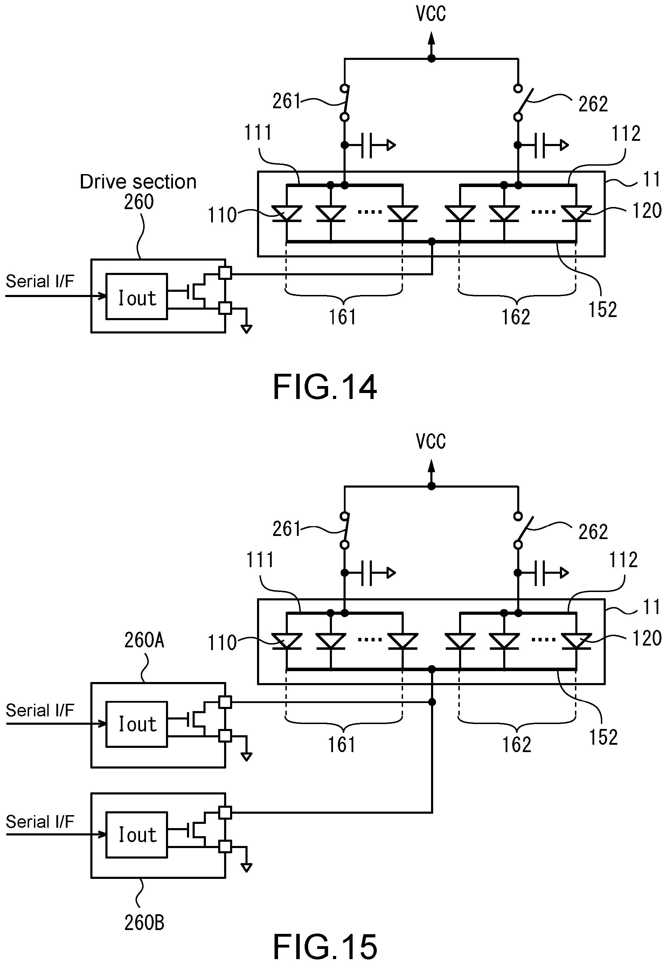

Fig. 14 illustrates an example of a configuration of a drive circuit included in the illumination apparatus 1. As illustrated in the figure, a drive section 260 is connected to the cathodes of the first-light-emitter group 161 and of the second-light-emitter group 162. Further, a switch 261 is connected to the anode of the first-light-emitter group 161, and a switch 262 is connected to the anode of the second-light-emitter group 162. Switching between light emission performed by the first-light-emitter group 161 and light emission performed by the second-light-emitter group 162 is performed using the switch 261 and the switch 262. One of the first-light-emitter group 161 and the second-light-emitter group 162 that is connected to a power supply (VCC) is supplied with a drive signal by the drive section 260.

Further, the switching between light emission performed by the first-light-emitter group 161 and light emission performed by the second-light-emitter group 162 may also be performed using two drive sections 260A and 260B, as illustrated in, for example, Fig. 15. As illustrated in the figure, a drive section 260A and a drive section 260B are connected to the cathodes of the first-light-emitter group 161 and of the second-light-emitter group 162. Further, the switch 261 is connected to the anode of the first-light-emitter group 161, and the switch 262 is connected to the anode of the second-light-emitter group 162.

In this configuration, the first-light-emitter group 161 and the second-light-emitter group 162 can be respectively supplied with drive signals by the two drive sections 260A and 260B under different drive conditions. The switching between the first-light-emitter group 161 and the second-light-emitter group 162 is performed using the two drive sections 260A and 260B, and this makes it possible to individually control drive conditions such as current and voltage with respect to the first-light-emitter group 161 and the second-light-emitter group 162. Note that, for example, the drive section 260 may be provided outside of the illumination apparatus 1 or may be internally included in the holding portion 21. Further, the light-emitting element 11 and the drive section 260 may be directly connected to each other.

### [Individual Driving]

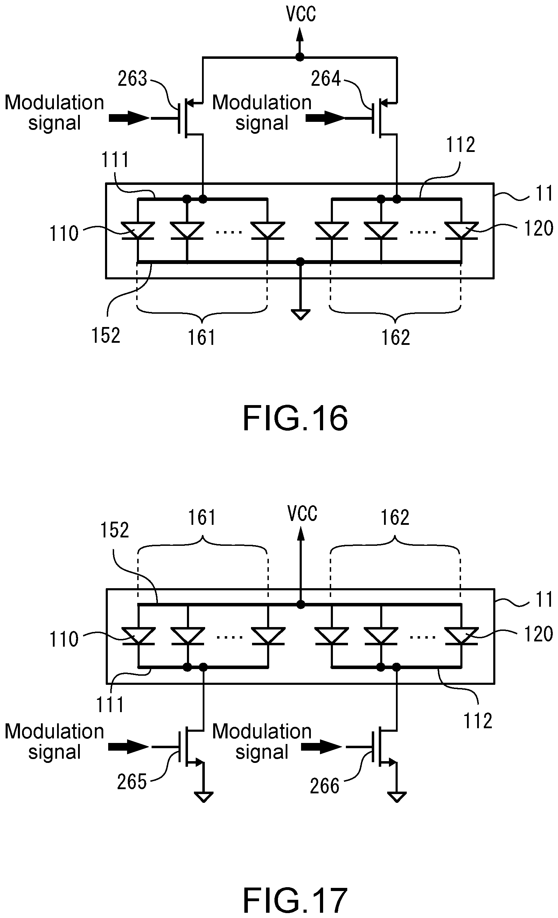

Fig. 16 illustrates another example of the configuration of the drive circuit included in the illumination apparatus 1. As illustrated in the figure, the cathodes of the first-light-emitter group 161 and of the second-light-emitter group 162 are connected to the ground. Further, the anode of the first-light-emitter group 161 is connected to a drive section 263, and the anode of the second-light-emitter group 162 is connected to a drive section 264.

The drive section 263 and the drive section 264 are transistors. When a modulation signal that determines a timing of ON/OFF modulation is supplied to the drive section, the first-light-emitter group 161 or the second-light-emitter group 162 is connected to the power supply (VCC) at an ON timing. Accordingly, current flows through each of the first-light-emitter group 161 and of the second-light-emitter group 162 at the ON timing to emit light. The anodes of the first-light-emitter group 161 and the second-light-emitter group 162 are completely separate, and the drive section 263 and the drive section 264 are respectively provided to the first-light-emitter group 161 and the second-light-emitter group 162. This makes it possible to drive the first-light-emitter group 161 and the second-light-emitter group 162 with different waveforms (at different timings with different currents).

Note that the drive section 263 and the drive section 264 may be metal-oxide semiconductor (MOS) transistors. Fig. 16 illustrates the drive section 263 and the drive section 264 of p-channel MOS transistors, but n-channel MOS transistors may be used. Further, the drive section 263 and the drive section 264 may be bipolar transistors instead of MOS transistors.

Fig. 17 illustrates another example of the configuration of the drive circuit included in the illumination apparatus 1. As illustrated in the figure, the anodes of the first-light-emitter group 161 and of the second-light-emitter group 162 are connected to the power supply (VCC). Further, the cathode of the first-light-emitter group 161 is connected to a drive section 265, and the cathode of the second-light-emitter group 162 is connected to a drive section 266.

The drive section 265 and the drive section 266 are transistors. When a modulation signal that determines a timing of ON/OFF modulation is supplied to the drive section, the first-light-emitter group 161 or the second-light-emitter group 162 is connected to the ground at an ON timing. Accordingly, current flows through each of the first-light-emitter group 161 and the second-light-emitter group 162 at the ON timing to emit light. The cathodes of the first-light-emitter group 161 and the second-light-emitter group 162 are completely separate, and the drive section 265 and the drive section 265 are respectively provided to the first-light-emitter group 161 and the second-light-emitter group 162. This makes it possible to drive the first-light-emitter group 161 and the second-light-emitter group 162 with different waveforms (at different timings with different currents).

Note that the drive section 265 and the drive section 266 may be MOS transistors. Fig. 17 illustrates the drive section 265 and the drive section 266 of n-channel MOS transistors, but p-channel MOS transistors may be used. Further, the drive section 265 and the drive section 266 may be bipolar transistors instead of MOS transistors.

With respect to the configuration of a drive circuit of the light-emitting element 11 illustrated in Figs. 16 and 17, the light-emitting element 11 may have an optimal circuit configuration according to electric characteristics of the light-emitting element 11 or according to a process technology of a transistor. For example, when the n-type portion is situated on a side of the lower DBR layer 141 (refer to Fig. 8), the drive circuit of the light-emitting element 11 may have a structure in which anodes are separate from each other, as illustrated in Fig. 16. When the p-type portion is situated on the side of the lower DBR layer 141, the drive circuit of the light-emitting element 11 may have a structure in which cathodes are separate from each other, as illustrated in Fig. 17.

### [Collective Driving]

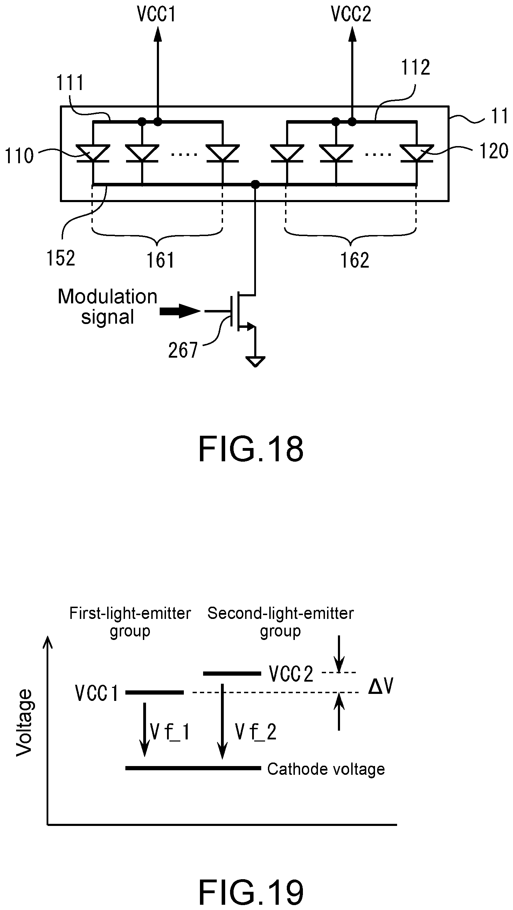

Fig. 18 illustrates another example of the configuration of the drive circuit included in the illumination apparatus 1. As illustrated in the figure, the cathodes of the first-light-emitter group 161 and of the second-light-emitter group 162 are connected to a drive section 267. Further, the anode of the first-light-emitter group 161 is connected to a first power supply (VCC1), and the anode of the second-light-emitter group 162 is connected to a second power supply (VCC2) .

The drive section 267 is a transistor. When a modulation signal that determines a timing of ON/OFF modulation is supplied to the drive section, the first-light-emitter group 161 and the second-light-emitter group 162 are connected to the ground at an ON timing. The first power supply (VCC1) applies a specified voltage to the first-light-emitter group 161, and the second power supply (VCC2) applies a specified voltage to the second-light-emitter group 162.

Fig. 19 is a graph in which a voltage of each node such as the first power supply (VCC1) and the second power supply (VCC2) in the configuration of Fig. 18 is given. A voltage of the first power supply (VCC1) corresponds to an anode voltage of the first-light-emitter group 161, and a voltage of the second power supply (VCC2) corresponds to an anode voltage of the second-light-emitter group 162. A difference between the anode voltage (VCC1) and a cathode voltage of the first-light-emitter group 161 corresponds to a drive voltage (Vf_1) of the first-light-emitter group 161, and a difference between the anode voltage (VCC2) and a cathode voltage of the second-light-emitter group 162 corresponds to a drive voltage (Vf_2) of the second-light-emitter group 162.

It is assumed that a difference between the anode voltage (VCC1) of the first-light-emitter group 161 and the anode voltage (VCC2) of the second-light-emitter group 162 is a potential difference Δ V, as illustrated in the figure. Δ V is, for example, 0.5 V. When the anode voltage (VCC1) of the first-light-emitter group 161 is set lower than the anode voltage (VCC2) of the second-light-emitter group 162 by Δ V, the drive voltage (Vf_1) of the first-light-emitter group 161 is lower than the drive voltage (Vf_2) of the second-light-emitter group 162 by Δ V since the first-light-emitter group 161 and the second-light-emitter group 162 have a shared cathode.

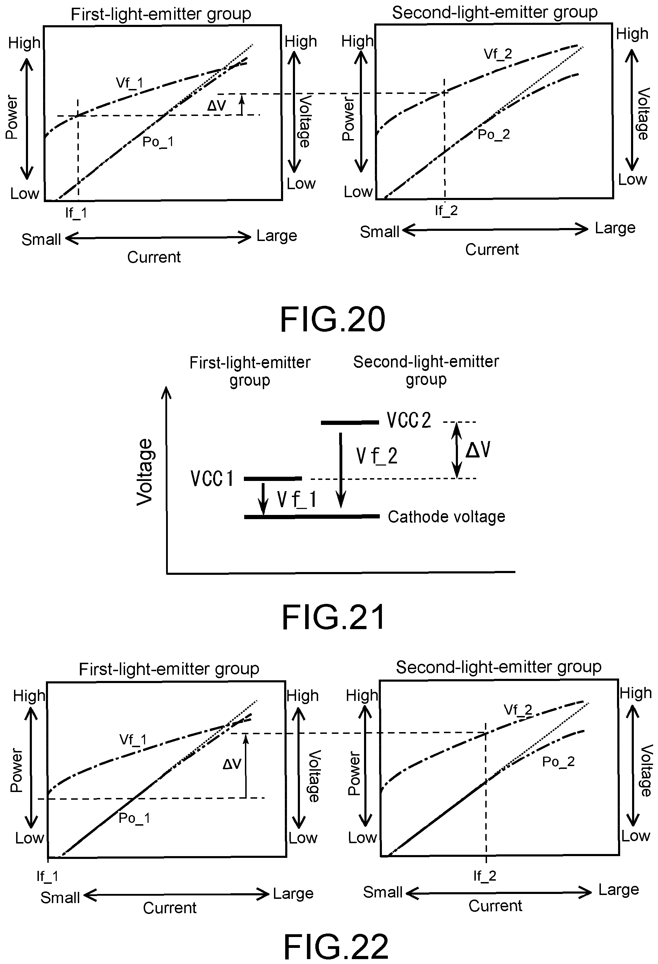

Fig. 20 is a graph in which a drive voltage, a driver current, and drive power of each of the first-light-emitter group 161 and the second-light-emitter group 162 are given. It is assumed that a drive current of the first-light-emitter group 161 is (If_1) and a drive current of the second-light-emitter group 162 is (If _2) in the figure. Further, it is assumed that drive power of the first-light-emitter group 161 is (Po_1) and drive power of the second-light-emitter group 162 is (Po_2). When the drive voltage (Vf_1) of the first-light-emitter group 161 is set lower than the drive voltage (Vf_2) of the second-light-emitter group 162 by Δ V, as illustrated in the figure, current that is caused by the drive section 267 to flow is divided into the drive current (If_1) and the drive current (If_2) such that the condition described above is satisfied.

When the anode voltage (VCC1) of the first-light-emitter group 161 is set lower than the anode voltage (VCC2) of the second-light-emitter group 162, as described above, this makes it possible to make the drive current (If _1) smaller and to make the drive current (If_2) larger, compared to when the anode voltages are equal.

Conversely, when the anode voltage (VCC1) of the first-light-emitter group 161 is set higher than the anode voltage (VCC2) of the second-light-emitter group 162, this makes it possible to make the drive current (If_1) larger and to make the drive current (If_2) smaller, compared to when the anode voltages are equal.

Further, when Δ V is made higher, this makes it possible to cause only one of the first-light-emitter group 161 and the second-light-emitter group 162 to emit light. Fig. 21 is a graph in which a voltage of each node such as the first power supply (VCC1) and the second power supply (VCC2) when Δ V is made higher in the configuration of Fig. 18, is given. When Δ V is made higher, as illustrated in the figure, the drive voltage (Vf_1) of the first-light-emitter group 161 is made further lower than the drive voltage (Vf_2) of the second-light-emitter group 162. Δ V in this case may be, for example, 1.5 V.

Fig. 22 is a graph in which a drive voltage, a driver current, and drive power of each of the first-light-emitter group 161 and the second-light-emitter group 162 are given. When the drive voltage (Vf_1) of the first-light-emitter group 161 is set lower than the drive voltage (Vf_2) of the second-light-emitter group 162 by Δ V, as illustrated in the figure, current that is caused by the drive section 267 to flow is divided into the drive current (If_1) and the drive current (If_2) such that the condition described above is satisfied. Consequently, the drive voltage (Vf_1) of the first-light-emitter group 161 is a voltage that is lower than a band-gap voltage, and no current flows into the first-light-emitter group 161 (If_1=0). Thus, all of the current caused by the drive section 267 to flow flows into the second-light-emitter group 162. In other words, the first-light-emitter group 161 is tuned off, and the second-light-emitter group 162 is turned on.

As described above, when the anode voltage (VCC1) of the first-light-emitter group 161 is set lower than the anode voltage (VCC2) of the second-light-emitter group 162 by a value lower than or equal to a certain value, this makes it possible to turn off the first-light-emitter group 161 and to turn on the second-light-emitter group 162. Conversely, when the anode voltage (VCC1) of the first-light-emitter group 161 is set higher than the anode voltage (VCC2) of the second-light-emitter group 162 by a value greater than or equal to a certain value, this makes it possible to turn on the first-light-emitter group 161 and to turn off the second-light-emitter group 162.

When the anode voltage (VCC1) of the first-light-emitter group 161 and the anode voltage (VCC2) of the second-light-emitter group 162 are adjusted in the configuration illustrated in Fig. 18, as described above, this also makes it possible to determine the drive current (If_1) and the drive current (If_2) and to control an amount of light emission performed by the first-light-emitter group 161 and an amount of light emission performed by the second-light-emitter group 162. Further, when a difference (Δ V) between the anode voltage (VCC1) of the first-light-emitter group 161 and the anode voltage (VCC2) of the second-light-emitter group 162 is made larger by a value greater than or equal to a certain value, this also makes it possible to perform an on/off control on the first-light-emitter group 161 and the second-light-emitter group 162. Note that Fig. 18 illustrates a circuit configuration in which the anodes of the first-light-emitter group 161 and of the second-light-emitter group 162 are separate. However, a circuit configuration in which the cathodes of the first-light-emitter group 161 and of the second-light-emitter group 162 are separate, as in the case of Fig. 17, may also be adopted.

### [Driving Performed by Switch Circuit]

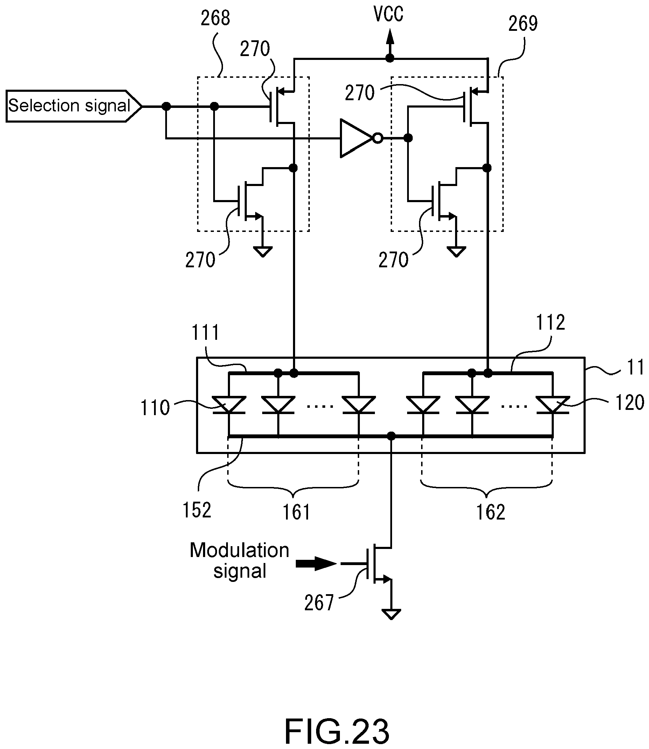

In the circuit configuration illustrated in Fig. 18, switching between light emission performed by the first-light-emitter group 161 and light emission performed by the second-light-emitter group 162 can be performed using a difference in voltage between the first power supply (VCC1) and the second power supply (VCC2), as described above. The switching between the light emissions can also be performed using a switch circuit. Fig. 23 illustrates the configuration of the drive circuit being included in the illumination apparatus 1 and including a switch circuit.

As illustrated in the figure, the cathodes of the first-light-emitter group 161 and of the second-light-emitter group 162 are connected to the drive section 267. Further, the anode of the first-light-emitter group 161 and the anode of the second-light-emitter group 162 are connected to the power supply (VCC). Furthermore, a first switch circuit 268 is provided between the anode of the first-light-emitter group 161 and the power supply (VCC) and between the anode of the first-light-emitter group 161 and the ground, and a second switch circuit 269 is provided between the anode of the second-light-emitter group 162 and the power supply (VCC) and between the anode of the second-light-emitter group 162 and the ground. The first switch circuit 268 and the second switch circuit 269 are each formed by two transistors 270.

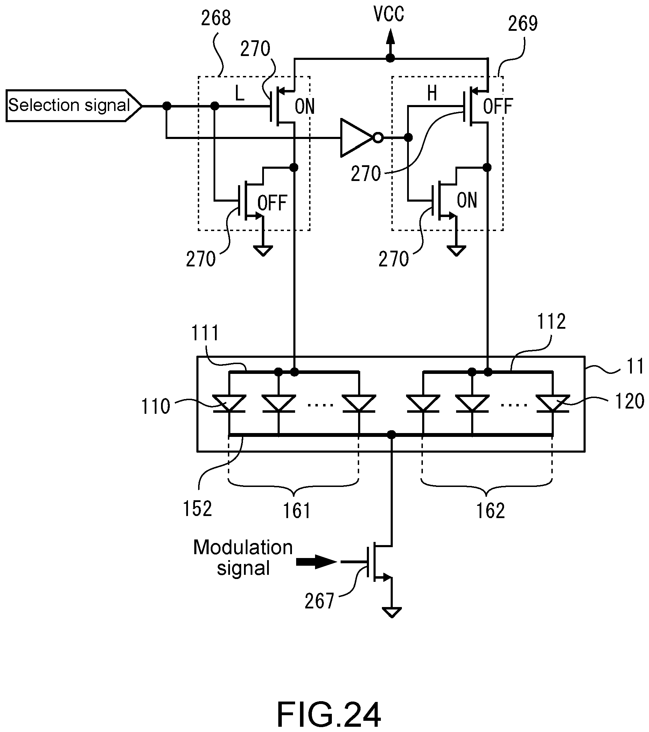

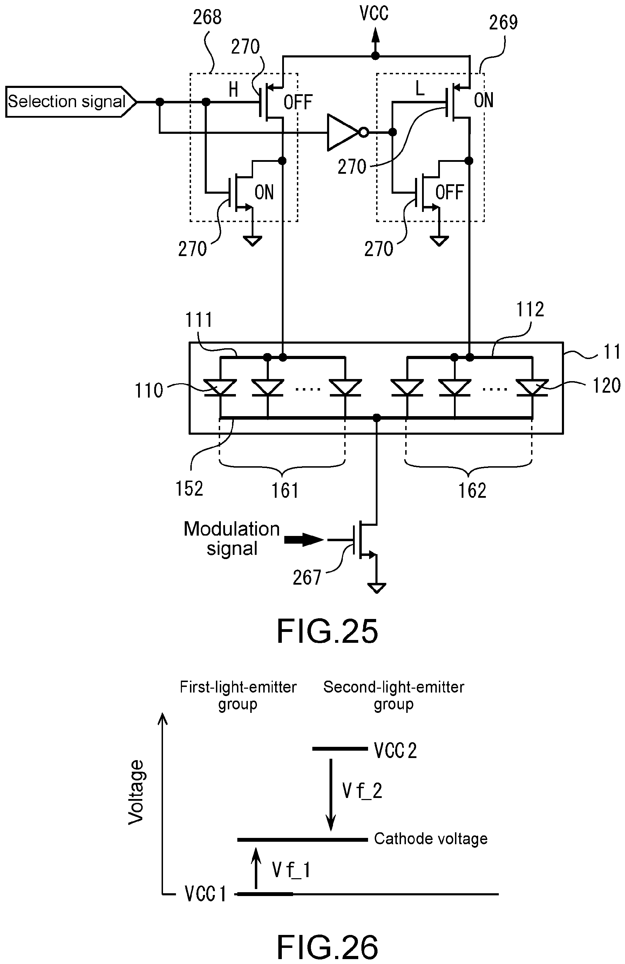

Figs. 24 and 25 schematically illustrate an operation of the drive circuit. When a selection signal is set to "L", as illustrated in Fig. 24, the anode of the first-light-emitter group 161 is connected to the power supply (VCC), and the anode of the second-light-emitter group 162 is connected to the ground. This results in the first-light-emitter group 161 emitting light, and in the second-light-emitter group 162 not emitting light. On the other hand, when the selection signal is set to "H", as illustrated in Fig. 25, the anode of the first-light-emitter group 161 is connected to the ground, and the anode of the second-light-emitter group 162 is connected to the power supply (VCC). This results in the second-light-emitter group 162 emitting light, and in the first-light-emitter group 161 not emitting light.

Fig. 26 is a graph in which a voltage of each node in the state illustrated in Fig. 25 is given. As illustrated in the figure, the drive voltage (Vf_1) of the first-light-emitter group 161 corresponds to a difference between the cathode voltage, and the anode voltage (VCC1) in the first-light-emitter terminal 24, and is a reverse bias. Consequently, no current flows into the first-light-emitter group 161. Thus, all of the current caused by the drive section 267 to flow flows into the second-light-emitter group 162. In other words, the first-light-emitter group 161 is tuned off, and the second-light-emitter group 162 is turned on.

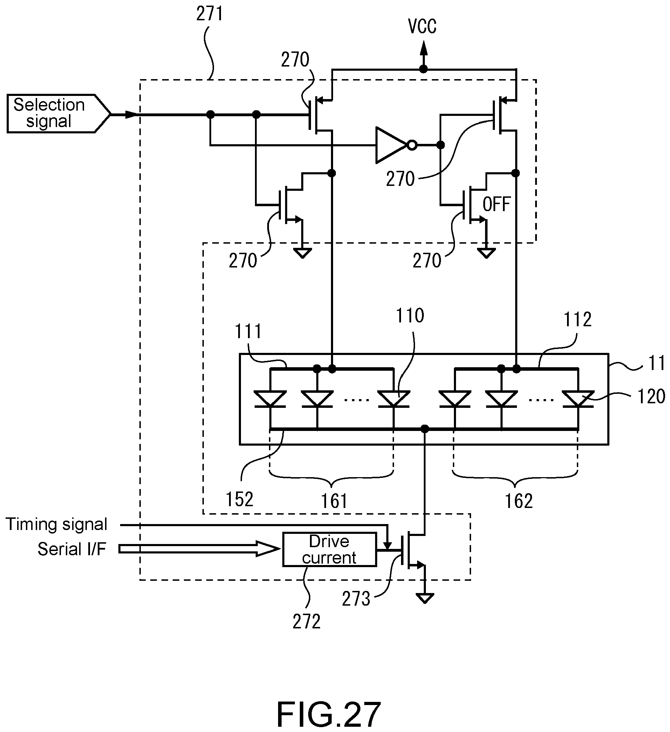

The circuit configuration illustrated in Fig. 23 may be integrated as a function of a laser drive integrated circuit (IC). Fig. 27 illustrates a drive circuit that is included in the illumination apparatus 1 and formed using an integrated circuit. As illustrated in the figure, this drive circuit is implemented by an integrated circuit 271. The integrated circuit 271 includes the transistor 270 described above, a resistor 272, and a drive transistor 273.

A magnitude of a drive current and a timing of ON/OFF modulation are two factors in a drive signal for each of the first-light-emitter group 161 and the second-light-emitter group 162. The magnitude of a drive current is stored in the resistor 272 in the form of digital data through a serial I/F, and a voltage depending on the digital data is supplied to the drive transistor 273. With respect to the modulation timing, a digital signal is provided as a timing signal, and control is performed to turn on or off the drive transistor 274 according to the timing signal. When the drive circuit is implemented by an integrated circuit, as described above, this makes it possible to provide a smaller switch circuit necessary to switch between light emitter groups at lower costs.

The illumination apparatus 1 may include the above-described drive circuit for the light-emitting element 11. Each drive circuit may be provided outside of the illumination apparatus 1 or may be internally included in the holding portion 21. Further, the light-emitting element 11 and the drive circuit may be directly connected to each other.

### (1-3. Wiring Pattern of First Light Emitter and Second Light Emitter)

In the light-emitting element 11, the first-light-emitter group 161 includes a plurality of first-light-emitter columns X each including a plurality of first light emitters 110 that extend in a direction, and the second-light-emitter group 162 includes a plurality of second-light-emitter columns Y each including a plurality of second light emitters 120 that extend in the direction, as described above (refer to Fig. 6). The first-light-emitter column X and the second-light-emitter column Y are alternately arranged.

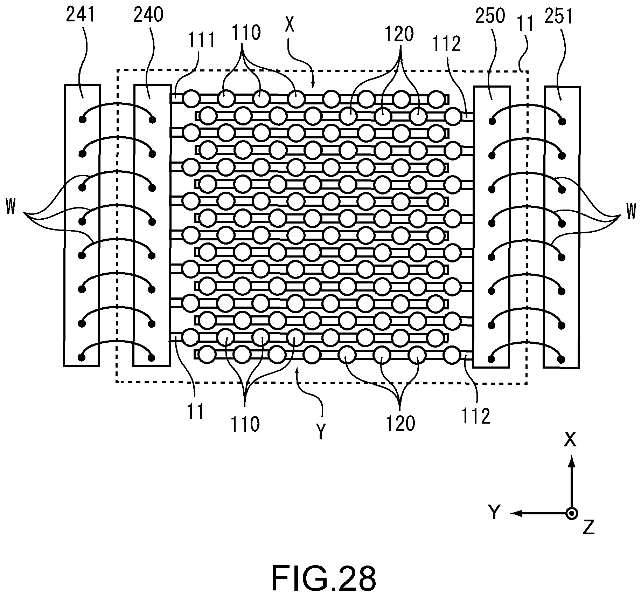

Fig. 28 is a plan view illustrating a wiring pattern in and an electrode arrangement for the light-emitting element 11. As illustrated in the figure, the first-light-emitter column X is formed by linear connection performed using the wiring 111, extends in a direction (the Y axis direction), and is connected to the first electrode pad 240 on the left. Further, the second-light-emitter column Y is formed by linear connection performed using the wiring 112, extends in the direction (the Y axis direction), and is connected to the second electrode pad 250 on the right.

The first electrode pad 240 is connected to a first light emitter electrode 241 for the light-emitting element 11 using wire bonding W, and is electrically connected to the first-light-emitter terminal 24 (refer to Fig. 1). Further, the second electrode pad 250 is connected to a second light emitter electrode 251 for the light-emitting element 11 using the wire bonding W, and is electrically connected to the second-light-emitter terminal 25 (refer to Fig. 1) .

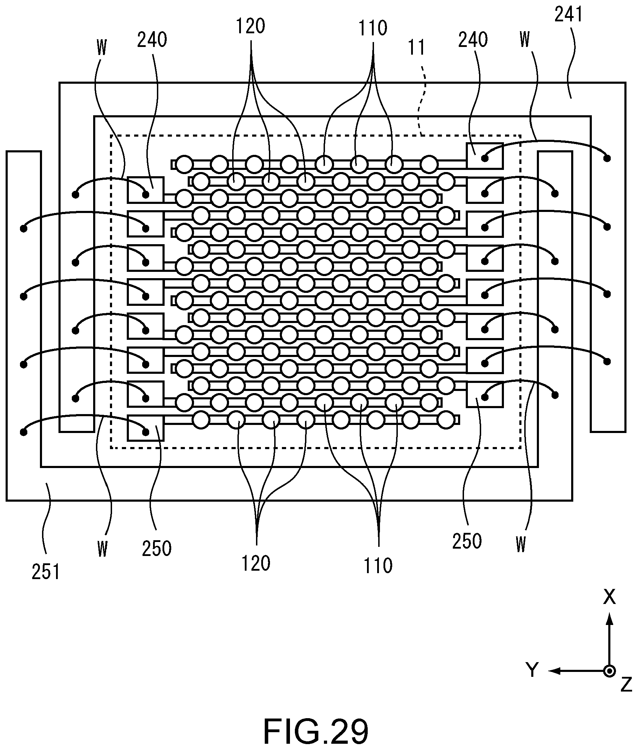

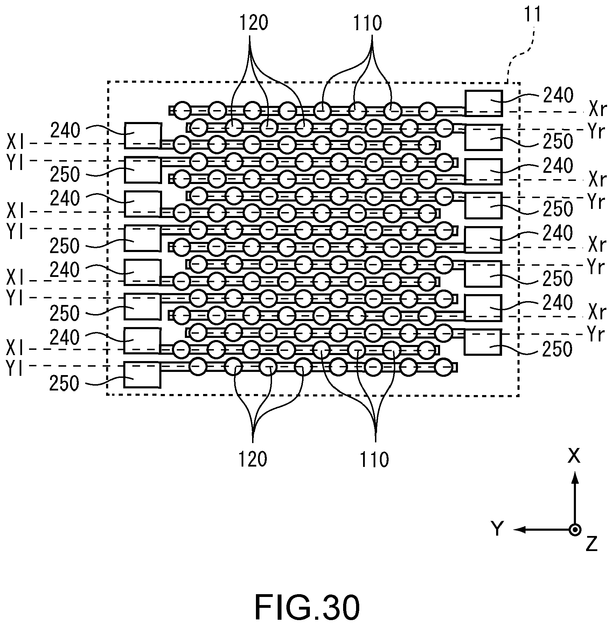

Fig. 29 is a plan view illustrating another wiring pattern in and another electrode arrangement for the light-emitting element 11, and Fig. 30 is a plan view only illustrating the wiring pattern in Fig. 29. As illustrated in Fig. 30, the first-light-emitter column X includes a first-light-emitter column Xr that is connected to the first electrode pad 240 situated on the right, and a first-light-emitter column Xl that is connected to the first electrode pad 240 situated on the left. The first-light-emitter column Xr and the first-light-emitter column Xl are alternately arranged in a state in which the second-light-emitter column Y is situated between the first-light-emitter column Xr and the first-light-emitter column Xl. The second-light-emitter column Y includes a second-light-emitter column Yr that is connected to the second electrode pad 250 situated on the right, and a second-light-emitter column Yl that is connected to the second electrode pad 250 situated on the left. The second-light-emitter column Yr and the second-light-emitter column Yl are alternately arranged in a state in which the first-light-emitter column X is situated between the second-light-emitter column Yr and the second-light-emitter column Yl.

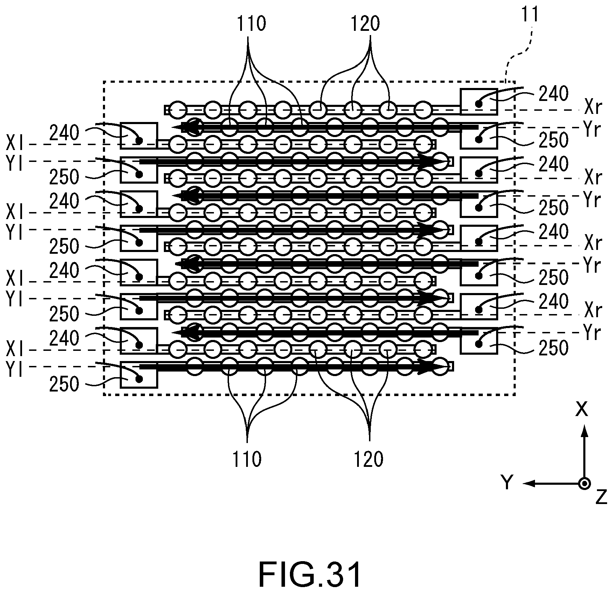

Fig. 31 schematically illustrates a flow of current through the second-light-emitter column Y in the wiring pattern illustrated in Fig. 29, where the flow of current is indicated using arrows. As illustrated in the figure, current flowing through the second-light-emitter column Yr and current flowing through the second-light-emitter column Yl flow in directions opposite to each other. Thus, a magnetic field generated by current flowing through the second-light-emitter column Yr and a magnetic field generated by current flowing through the second-light-emitter column Yl cancel each other out. This makes it possible to reduce an effective inductance and thus to improve high-speed modulation characteristics. Note that the second-light-emitter column Y has been described above, but also in the first-light-emitter column X, a magnetic field generated in the first-light-emitter column Xr and a magnetic field generated in the first-light-emitter column Xl cancel each other out, and this makes it possible to improve high-speed modulation characteristics.

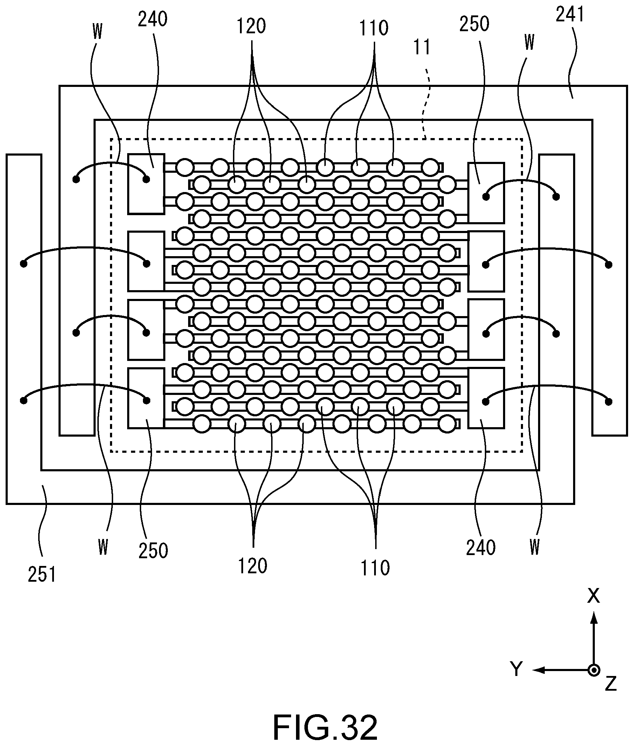

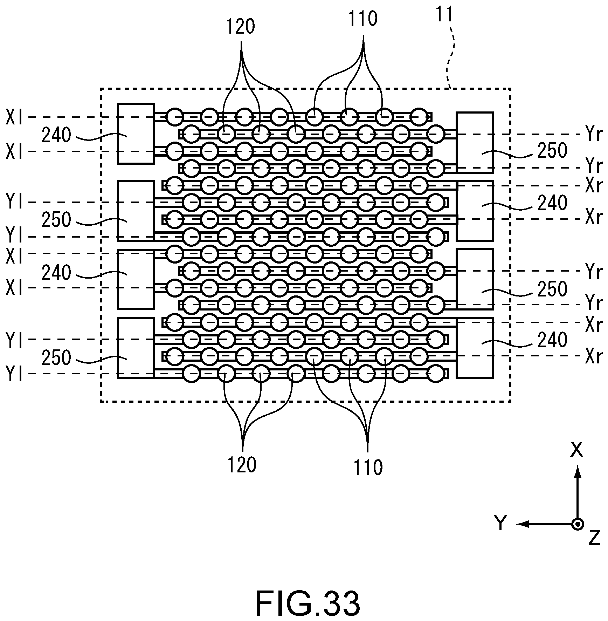

Fig. 32 is a plan view illustrating another wiring pattern in and another electrode arrangement for the light-emitting element 11, and Fig. 33 is a plan view only illustrating the wiring pattern in Fig. 32. As illustrated in Fig. 33, the first-light-emitter column X includes the first-light-emitter column Xr connected to the first electrode pad 240 situated on the right, and the first-light-emitter column Xl connected to the first electrode pad 240 situated on the left. A set of two first-light-emitter columns Xr and a set of two first-light-emitter columns Xl are alternately arranged in a state in which the second-light-emitter column Y is situated between the first-light-emitter column X. The second-light-emitter column Y includes the second-light-emitter column Yr connected to the second electrode pad 250 situated on the right, and the second-light-emitter column Yl connected to the second electrode pad 250 situated on the left. A set of two second-light-emitter columns Yr and a set of two second-light-emitter columns Yl are alternately arranged in a state in which the first-light-emitter column X is situated between the second-light-emitter column Y.

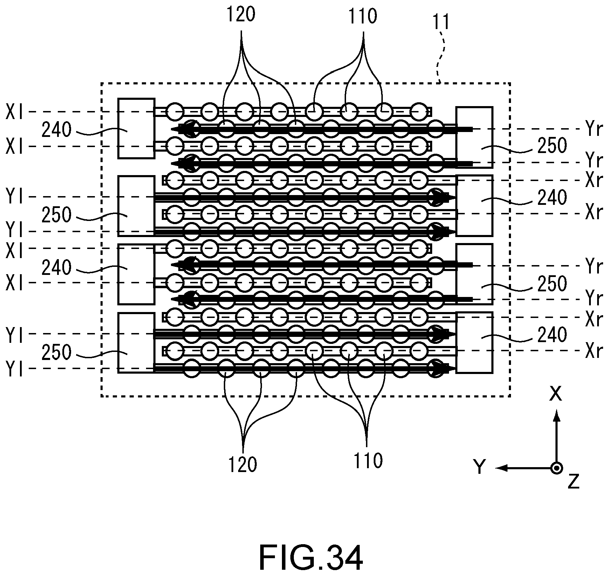

Fig. 34 schematically illustrates a flow of current through the second-light-emitter column Y in the wiring pattern illustrated in Fig. 32, where the flow of current is indicated using arrows. As illustrated in the figure, current flowing through the second-light-emitter column Yr and current flowing through the second-light-emitter column Yl flow in directions opposite to each other. Thus, a magnetic field generated by current flowing through the second-light-emitter column Yr and a magnetic field generated by current flowing through the second-light-emitter column Yl cancel each other out. This makes it possible to reduce an effective inductance and thus to improve high-speed modulation characteristics, although the wiring pattern illustrated in Fig. 32 is inferior to the wiring pattern illustrated in Fig. 29.

Further, this configuration makes it possible to make the areas of the first electrode pad 240 and the second electrode pad 250 larger, compared to the wiring pattern illustrated in Fig. 29. Thus, the wire bonding W can be easily provided, and the wiring pattern having this configuration can also be used when wiring spacing is small. Note that the second-light-emitter column Y has been described above, but also in the first-light-emitter column X, a magnetic field generated in the first-light-emitter column Xr and a magnetic field generated in the first-light-emitter column Xl cancel each other out, and this makes it possible to improve high-speed modulation characteristics.

### (1-4. Sequence of Light Emission Performed by Illumination Apparatus)

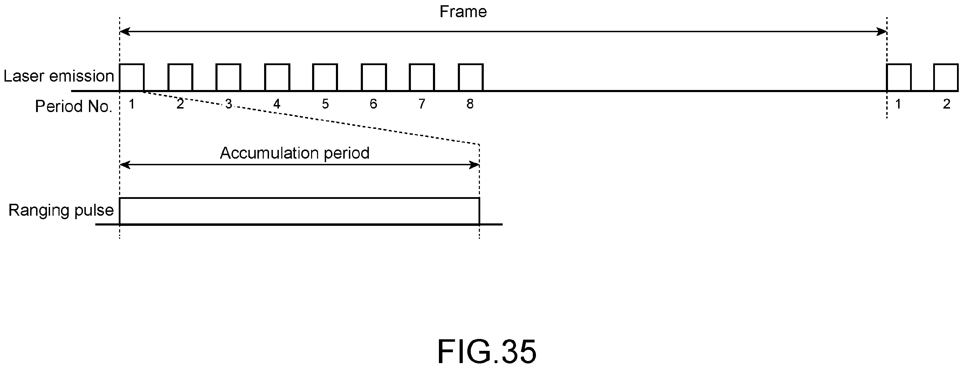

Fig. 35 illustrates a general sequence of light emission of a ranging pulse in an indirect ToF approach. A period in which one ranging image is generated is called a "frame", and one frame is set to a time period such as 33.3 milliseconds (a frequency of 30 Hz). For example, a continuous square wave of 100 MHz in which a duty = 50% is used as a ranging pulse, and this results in light emission being continuously performed in an accumulation period. A plurality of accumulation periods having different conditions can be provided in a frame. Fig. 35 illustrates eight accumulation periods, but the number of accumulation periods is not limited thereto.

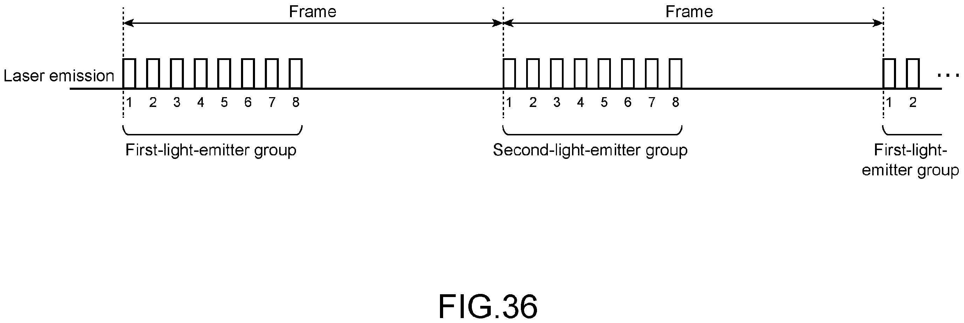

Fig. 36 illustrates an example of a sequence of light emission performed by the illumination apparatus 1. As illustrated in the figure, in the illumination apparatus 1, the first-light-emitter group 161 emits light in one frame, and the light-receiving section 210 (refer to Fig. 2) receives reflected light to generate a ranging image. In the next frame, the second-light-emitter group 162 emits light, and the light-receiving section 210 receives reflected light to generate a ranging image. In Fig. 36, switching is performed between the first-light-emitter group 161 and second-light-emitter group 162 for each frame, but the switching may be performed for each plurality of frames.

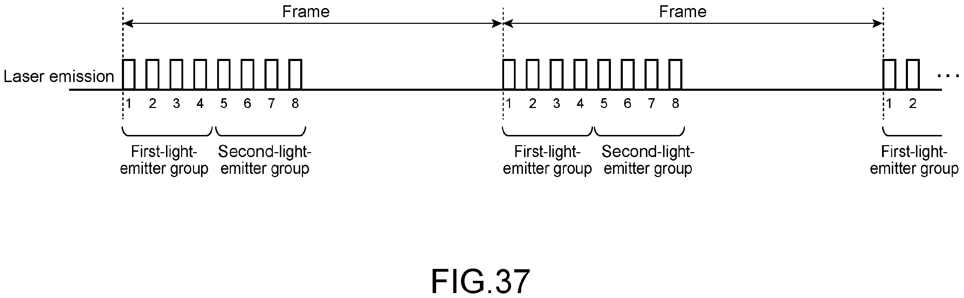

Fig. 37 illustrates an example of another sequence of light emission performed by the illumination apparatus 1. As illustrated in the figure, in the illumination apparatus 1, both the first-light-emitter group 161 and the second-light-emitter group 162 may emit light successively in one frame, and the light-receiving section 210 may generate a ranging image. This light-emitting sequence makes it possible to generate a ranging image obtained by combining ranging information generated by light emitted by the first-light-emitter group 161 and ranging information generated by light emitted by the second-light-emitter group 162.

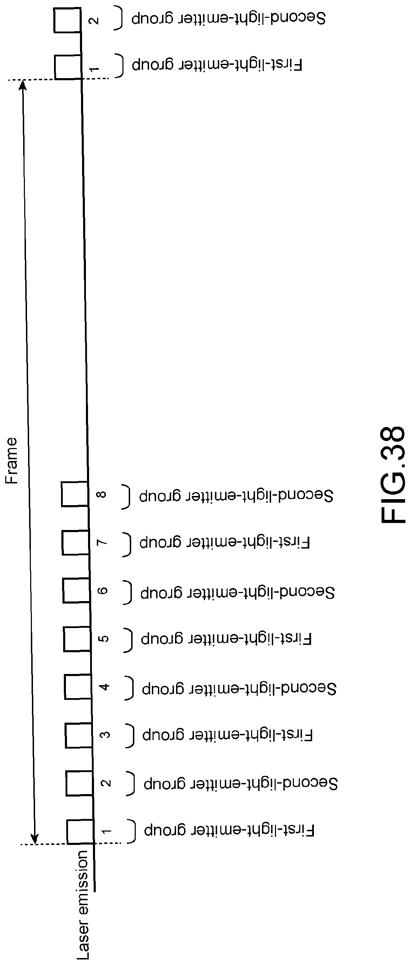

Fig. 38 illustrates an example of yet another sequence of light emission performed by the illumination apparatus 1. As illustrated in the figure, in the illumination apparatus 1, the first-light-emitter group 161 and the second-light-emitter group 162 may emit light alternately for each accumulation time period, and the light-receiving section 210 may generate a ranging image.

### (1-5. Configuration of Ranging Apparatus)

The ranging apparatus 100 measures a distance using a ToF approach. The ranging apparatus 100 includes, for example, the illumination apparatus 1, the light-receiving section 210, a controller 220, and a ranging section 230 (refer to Fig. 2).

As described above, the illumination apparatus 1 switches between light emission performed by a plurality of first light emitters 110 and light emission performed by a plurality of second light emitters 120 to irradiate a light beam onto the target 1000 in the form of a spot (spot irradiation) and to irradiate a light beam onto the target 1000 with a substantially uniform degree of intensity of light (uniform irradiation). For example, the illumination apparatus 1 causes irradiation light to be generated in synchronization with a light emission controlling signal CLKp of a square wave. Further, the light emission controlling signal CLKp is not limited to a square wave if the light emission controlling signal CLKp may be a periodic signal. For example, the light emission controlling signal CLKp may be a sine wave.

The light-receiving section 210 receives light reflected off the irradiation target 1000, and detects an amount of light received in a period of a vertical synchronization signal VSYNC every time the period elapses. For example, a periodic signal of 60 hertz (Hz) is used as the vertical synchronization signal VSYNC. Further, the light-receiving section 210 includes a plurality of pixel circuits arranged in a two-dimensional grid. The light-receiving section 210 supplies the ranging section 230 with image data (a frame) that corresponds to an amount of light received by the pixel circuits. Note that the frequency of the vertical synchronization signal VSYNC is not limited to 60 hertz (Hz), and may be 30 hertz (Hz) or 120 hertz (Hz) .

The controller 220 controls the illumination apparatus 1. The controller 220 generates the light emission controlling signal CLKp, and supplies the generated light emission controlling signal CLKp to the illumination apparatus 1 and the light-receiving section 210. The frequency of the light emission controlling signal CLKp is, for example, 20 megahertz (MHz). Note that the frequency of the light emission controlling signal CLKp is not limited to 20 megahertz (MHz), and may be, for example, 5 megahertz (MHz).

The ranging section 230 measures a distance to the irradiation target 1000 on the basis of the image data using a ToF approach. The ranging section 230 measures the distance for each pixel circuit, and generates a depth map in which a distance to an object is represented by a gradation value for each pixel. For example, the depth map is used to perform image processing including processing of blurring of a level depending on the distance or to perform autofocus (AF) processing of calculating a focal point for a focus lens according to the distance.

### (1-6. Operations and Effects)

In the illumination apparatus 1 of the present embodiment, the microlens array 12 forming a beam shape of, for example, the laser beam L120 used to perform uniform irradiation and causing the laser beam L120 to exit the microlens array 12 is arranged in paths of the light L1 (the laser beam L110) and of the light L2 (the laser beam L120), the light L1 and the light L2 being emitted by the light-emitting element 11 including a plurality of light emitters (the first light emitter 110 and the second light emitter 120) forming the first-light-emitter group 161 and the second-light-emitter group 162 that are respectively used to perform spot irradiation and uniform irradiation. This makes it possible to shift, in an optical-axis direction, light-emitting points for the laser beam L110 and the laser beam L120 that are respectively emitted by the first light emitter 110 and the second light emitter 120. This is described below.

As described above, the following methods are performed by a ranging apparatus using a ToF approach: a method including uniformly irradiating an entire measurement-target range with pieces of light emitted by a plurality of light emitters, and a method including making pieces of light emitted by a plurality of light emitters substantially parallel using a collimator lens and irradiating the pieces of substantially parallel light onto an entire measurement-target range in the form of spots.

In general, a ranging apparatus that includes two light sources respectively used to perform uniform irradiation and spot irradiation is used as a technology that reduces a ranging error caused due to light being scattered by a measurement target. Moreover, the ranging apparatus including two light sources respectively used to perform uniform irradiation and spot irradiation can increase a ranging distance by increasing a degree of light density using spot irradiation and can compensate for a reduction in XY resolution using uniform irradiation.

As described above, using two light sources of different irradiation patterns is a technology that is effective in improving the ranging accuracy. On the other hand, the use of two light sources results in increasing costs and in making an apparatus larger in size. Further, the adjustment of positions of two light sources relative to each other upon manufacturing a ranging apparatus, and a positional shift between the two light sources that is caused due to change over time are also issues caused when the two light sources are used.

On the other hand, in the present embodiment, the microlens array 12 is arranged in light paths of the laser beam L110 and of the laser beam L120, the laser beam L110 and the laser beam L120 being emitted by the light-emitting element 11 including the first light emitter 110 used to perform spot irradiation and the second light emitter 120 used to perform uniform irradiation. The microlens array 12 includes the lens portion 12A and the parallel flat plate portion 12B, where, for example, the laser beam L110 emitted by the first light emitter 110 is incident on the parallel flat plate portion 12B, and the laser beam L120 emitted by the second light emitter 120 is incident on the lens portion 12A. Consequently, the laser beam L120 incident on the lens portion 12A is refracted by a lens surface of the lens portion 12A, and a beam shape of the laser beam L120 is changed to form, for example, the virtual light-emitting point P2' in the microlens array 12. This makes it possible to change positions of the light-emitting points P1 and P2 to different positions in the optical-axis direction.

As described above, for example, the illumination apparatus 1 of the present embodiment makes it possible to perform spot irradiation and uniform irradiation onto the irradiation target 1000 without using an adjustment mechanism that, for example, mechanically adjusts a position of an optical member (such as the collimator lens 13) according to the irradiation mode, the optical member being arranged in a direction of light emission performed by the first light emitter 110 used to perform spot irradiation and by the second light emitter 120 used to perform uniform irradiation. This results in being able to make the illumination apparatus 1 and the ranging apparatus 100 including the illumination apparatus 1 smaller in size.

Further, there is no need for the above-described adjustment mechanism in the present embodiment. This makes it possible to reduce costs. Furthermore, a positional shift in optical member, and the like that are caused due to change over time do not occur. This makes it possible to improve the reliability. Furthermore, the present embodiment makes it possible to switch between irradiation modes quickly. This results in being able to accurately measure a distance to a moving object.

Further, in the present embodiment, a surface-emitting semiconductor laser that includes a plurality of light emitters is used as a light source, where a portion of the plurality of light emitters is used as the first light emitters 110 used to perform spot irradiation, and another portion of the plurality of light emitters is used as the second light emitters 120 used to perform uniform irradiation, compared to when an illumination apparatus used to perform spot irradiation and an illumination apparatus used to perform uniform irradiation are separately provided. Accordingly, switching between spot irradiation and uniform irradiation that are performed onto the irradiation target 1000 can be performed discretionarily by switching between light emission performed by the first-light-emitter group 161 including the first light emitters 110 and light emission performed by the second-light-emitter group 162 including the second light emitters 120. This makes it possible to further reduce costs.

Further, there is no need to, for example, adjust positions of a light source used to perform spot irradiation and a light source used to perform uniform irradiation relative to each other, as described above. This makes it possible to provide an illumination apparatus that can more easily perform spot irradiation and uniform irradiation.

Furthermore, in the present embodiment, respective light-emitting regions (the OA diameters W1 and W2) of the first light emitter 110 used to perform spot irradiation and the second light emitter 120 used to perform uniform irradiation are set such that the OA diameter W1 of the first light emitter 110 is relatively small and the OA diameter W2 of the second light emitter 120 is relatively large. This makes it possible to concentrate the laser beam L110 used to perform spot irradiation. Further, this makes it possible to improve the uniformity of intensity of light and optical output upon performing uniform irradiation.

Further, the above-described drive circuit is used to drive the light-emitting element 11, and this makes it possible to modulate the first light emitter 110 and the second light emitter 120 at a high speed. High-speed modulation characteristics can be improved by setting, to be the wiring pattern of the first-light-emitter column X and the second-light-emitter Y, the above-described wiring pattern in which currents flow in directions opposite to each other such that magnetic fields cancel each other out. This makes it possible to improve high-speed modulation characteristics.

Next, first to sixth modifications of the present disclosure are described. A structural element that is similar to a structural element in the embodiments described above is hereinafter denoted by the same reference numeral, and a description of it is omitted as appropriate.

### <2. Modifications>

### (2-1. First Modification)

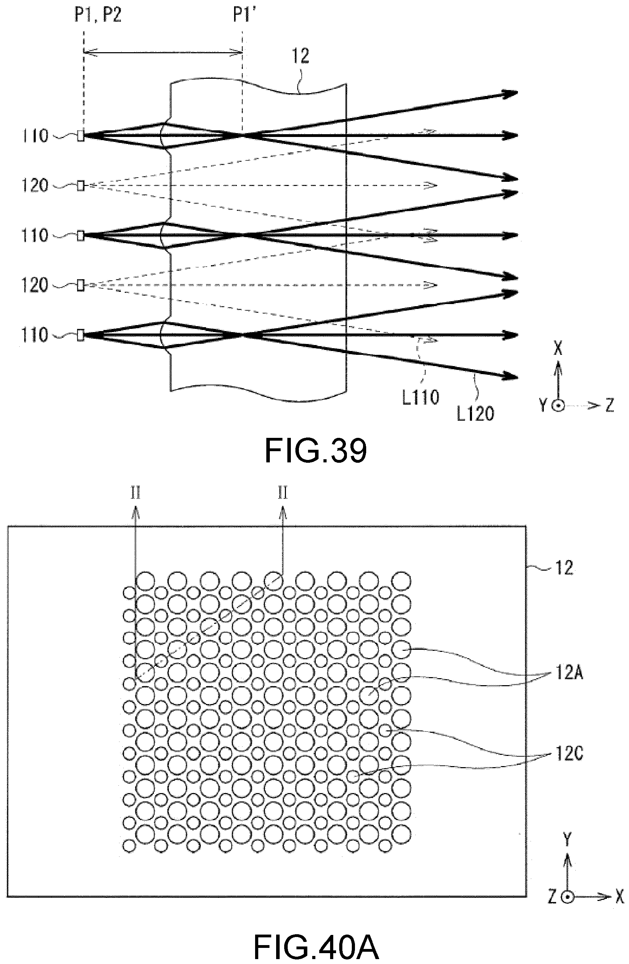

Fig. 39 illustrates a beam forming function of the microlens array 12 according to a first modification of the present disclosure. The example in which arrangement is made such that the lens portion 12A faces the second light emitter 120 used to perform uniform irradiation and such that the parallel flat plate portion 12B faces the first light emitter 110 used to perform spot irradiation has been described in the embodiments above. Without being limited thereto, arrangement may be made such that the lens portion 12A faces the first light emitter 110 used to perform spot irradiation and such that the parallel flat plate portion 12B faces the second light emitter 120 used to perform uniform irradiation. Such a configuration can also provide effects that are similar to the effects provided in the embodiments described above.

### (2-2. Second Modification)

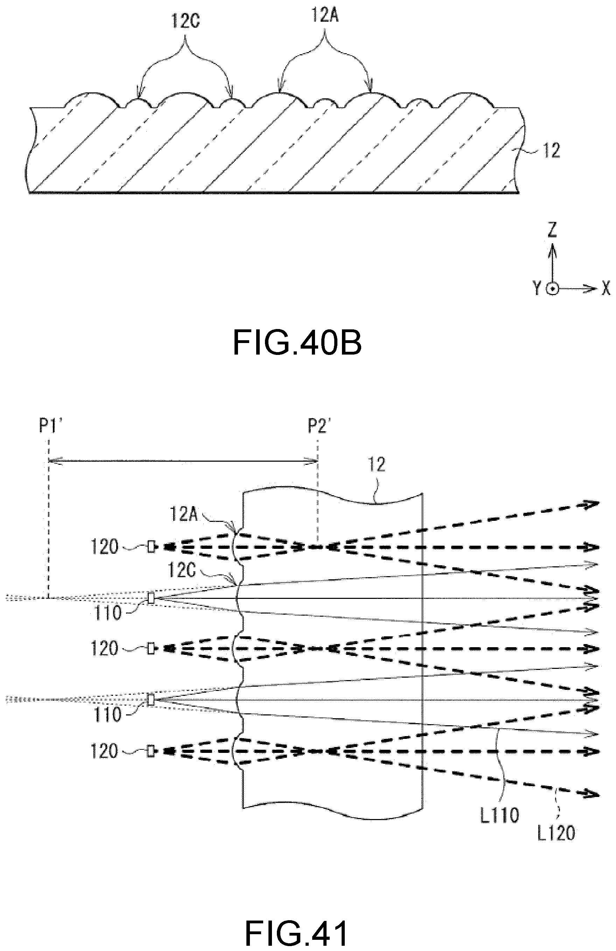

Fig. 40A schematically illustrates an example of a planar configuration of the microlens array 12 according to a second modification of the present disclosure, and Fig. 40B schematically illustrates a configuration of a cross section of the microlens array 12 along the line II-II illustrated in Fig. 40A. The microlens array 12 illustrated in Figs. 40A and 40B is formed by two types of microlenses of different radiuses of curvature being arranged in an array, and includes a plurality of lens portions 12A and a plurality of lens portions 12C, the lens portion 12A and the lens portion 12C having different radiuses of curvature.

The configuration in which one of the laser beam L110 emitted by the first light emitter 110 and the laser beam L120 emitted by the second light emitter 120 is incident on the lens portion 12A, and another of the laser beam L110 and the laser beam L120 is incident on the parallel flat plate portion 12B has been described in the embodiments above and the like. However, the configuration is not limited thereto.

For example, arrangement may be made such that the second light emitter 120 used to perform uniform irradiation faces the lens portion 12A and such that the first light emitter 110 used to perform spot irradiation faces the lens portion 12C, and the laser beam L110 and laser beam L120 respectively emitted by the first light emitters 110 and 120 may be respectively incident on the lens portion 12C and the lens portion 12A, as illustrated in, for example, Fig. 41.

Consequently, the laser beam L120 emitted by the second light emitter 120 is refracted by a lens surface of the lens portion 12A to form, for example, the virtual light-emitting point P2' in the microlens array 12, as illustrated in Fig. 41. The laser beam L110 emitted by the first light emitter 110 is refracted by a lens surface of the lens portion 12C to form, for example, a virtual light-emitting point P1' behind the first light emitter 110.

As described above, in this modification, the microlens array 12 including two types of lens portions (the lens portion 12A and the lens portion 12C) of different radiuses of curvature is used so that the laser beam L110 emitted by the first light emitter 110 used to perform spot irradiation and the laser beam L120 emitted by the second light emitter 120 used to perform uniform irradiation are incident on the respective lens portions to form beam shapes of both the laser beam L110 and the laser beam L120. This makes it possible to more greatly change positions of light-emitting points (the virtual light-emitting points P1' and P2') for the respective laser beams to different positions in the optical-axis direction, in addition to the effects provided by the embodiments described above.

Further, when positions of the virtual light-emitting points P1' and P2' of the first light emitter 110 and the second light emitter 120 are more greatly changed to different positions in the optical-axis direction, as described above, this makes it possible to easily arrange the microlens array 12 at a position prior to a position at which the laser beams L110 and L120 respectively emitted by the first light emitter 110 and the second light emitter 120 overlap. This makes it possible to easily effectively use the laser beams L110 and L120. This makes it possible to, for example, further improve the uniformity of intensity of light upon performing uniform irradiation.

### (2-3. Third Modification)

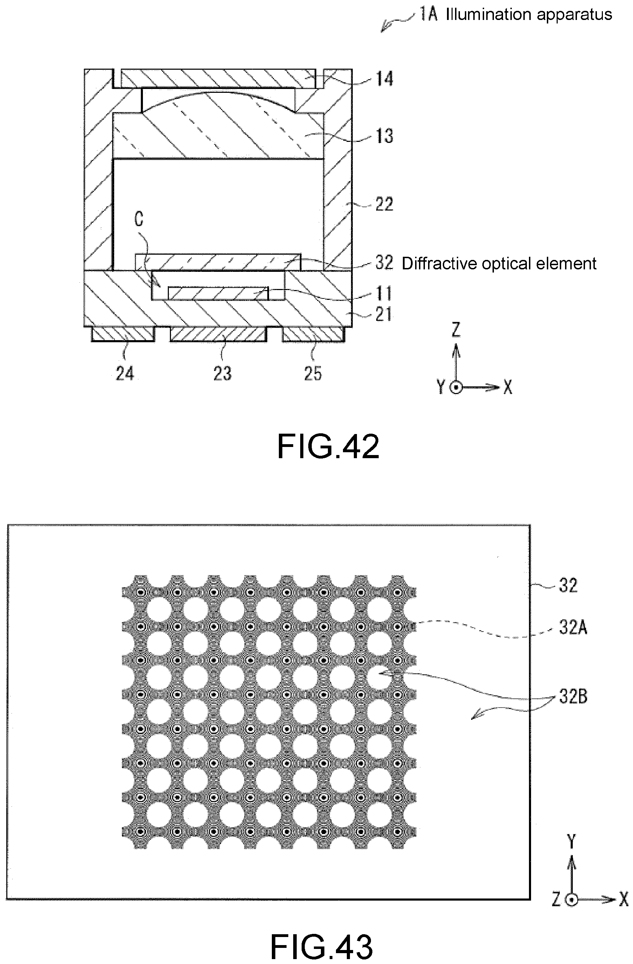

Fig. 42 is a cross-sectional view schematically illustrating an example of a schematic configuration of an illumination apparatus (an illumination apparatus 1A) according to a third modification of the present disclosure. The illumination apparatus 1A of this modification is different from the illumination apparatus of the embodiments described above in using a diffractive optical element (DOE) 32 as the second optical member.

From between pieces of light (the laser beam L110 and the laser beam L120) emitted by the first light emitter 110 used to perform spot irradiation and the second light emitter 120 used to perform uniform irradiation, the diffractive optical element 32 forms a beam shape of, for example, at least one of the pieces of light, and causes the pieces of light to exit the diffractive optical element 32. Fig. 43 schematically illustrates an example of a planar configuration of the diffractive optical element 32, and, for example, the diffractive optical element 32 is arranged such that the second light emitter 120 faces a region 32A and the first light emitter 110 faces a region 32B.

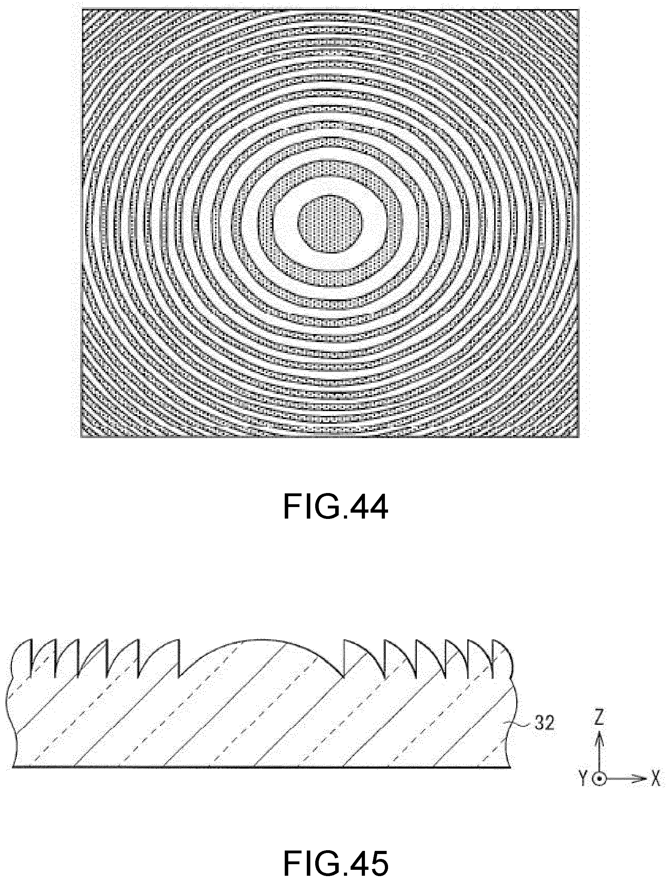

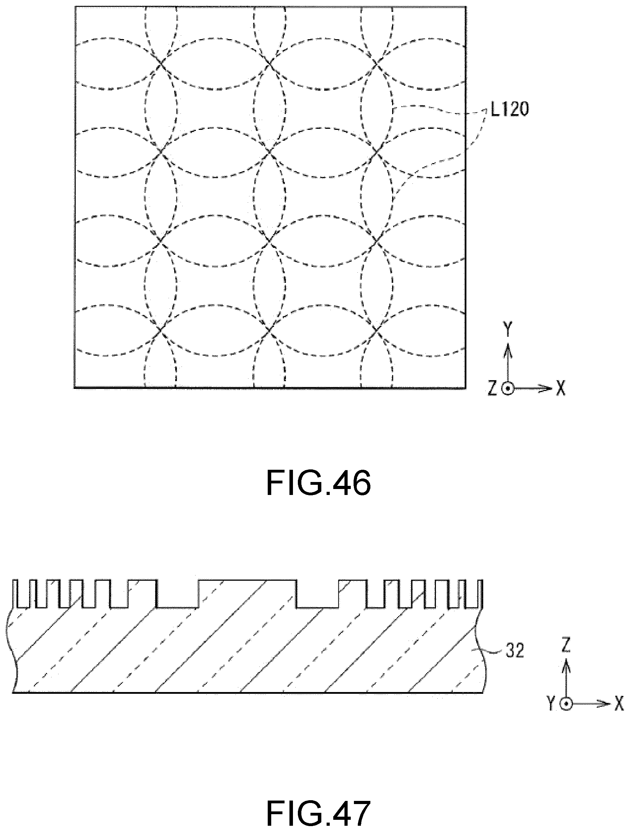

For example, a Fresnel lens that has, on the region 32A, a planar pattern as illustrated in Fig. 44 and a cross-sectional pattern as illustrated in Fig. 45 may be used as the diffractive optical element 32. Note that the region 32B is, for example, a parallel flat plate region. When a Fresnel lens is used as the diffractive optical element 32, the laser beam L120 emitted by the second light emitter 120 may form, for example, an irradiation pattern as illustrated in Fig. 46 on the irradiation target 1000.

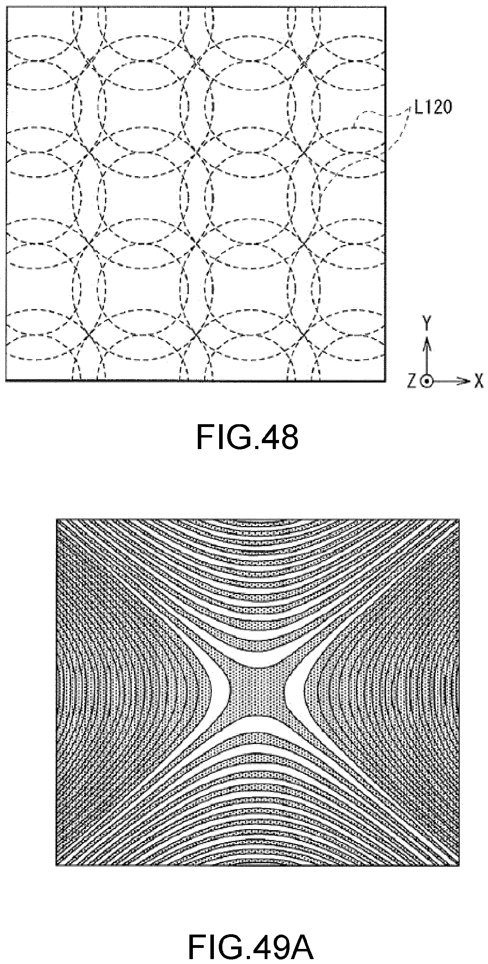

Further, a binary lens that has a cross-sectional pattern as illustrated in Fig. 47 on the region 32A may be used as the diffractive optical element 32. When a binary lens is used as the diffractive optical element 32, the laser beam L120 emitted by the second light emitter 120 may form, for example, an irradiation pattern as illustrated in Fig. 48 by + first order light and - first order light overlapping.

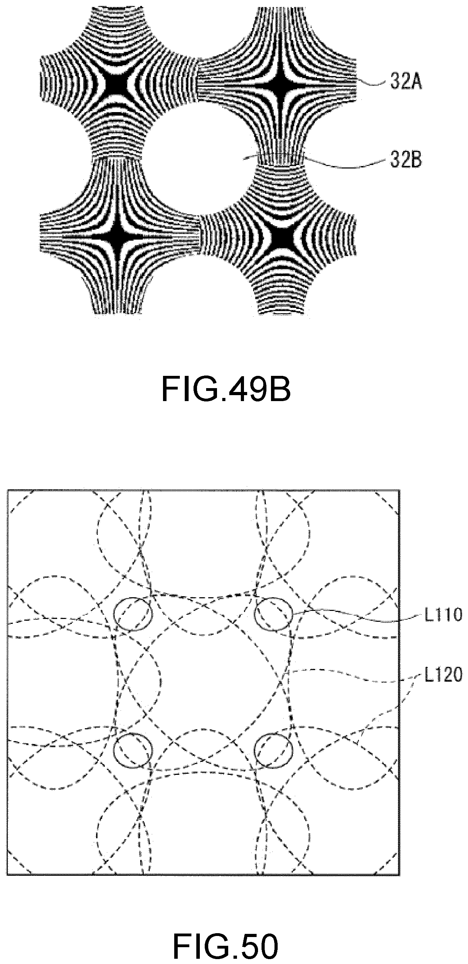

Furthermore, a DOE corresponding to a saddle-shaped lens that has a planar pattern as illustrated in Fig. 49A on the region 32A may be used as the diffractive optical element 32. As illustrated in Fig. 49B, in this DOE, the planar patterns illustrated in Fig. 49A are arranged in a state in which a certain planar pattern is arranged adjacently to another planar pattern obtained by the certain planar pattern being rotated 45 degrees. The use of such a DOE as the diffractive optical element 32 results in the laser beam L120 emitted by the second light emitter 120 forming, for example, an irradiation pattern illustrated in Fig. 50. This makes it possible to, for example, prevent a degree of uniformity from being reduced due to a shift in the optical-axis direction.

As described above, the diffractive optical element 32 such as a Fresnel lens is used as the second optical member of the present disclosure in this modification. This makes it possible to further improve the uniformity of intensity of light upon performing uniform irradiation, compared to, for example, the embodiments described above in which the microlens array 12 is used as the second optical member of the present disclosure to form a beam shape of the second light emitter 120 by diffracting the laser beam L120 emitted by the second light emitter 120 used to perform uniform irradiation.

Note that, in addition to the microlens array 12 and the diffractive optical element 32 such as a Fresnel lens, as described above, a diffusion plate may be used as the second optical member of the present disclosure. When a diffusion plate is used as the second optical member, this results in being able to relax a desired positional accuracy and to reduce costs, compared to when the microlens array 12 or the diffractive optical element 32 is used.

### (2-4. Fourth Modification)

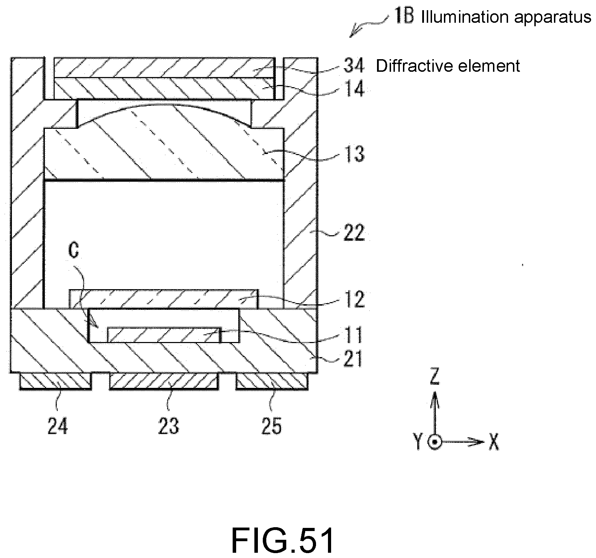

Fig. 51 is a cross-sectional view schematically illustrating an example of a schematic configuration of an illumination apparatus (an illumination apparatus 1B) according to a fourth modification of the present disclosure. The illumination apparatus 1B of this modification is different from the illumination apparatuses of the embodiments described above in arranging, for example, the diffractive element 14 and a diffractive element 34 on the output side of the collimator lens 13 in light paths of the laser beam L110 and laser beam L120 respectively emitted by the first light emitter 110 and the second light emitter 120.

The diffractive element 34 divides the laser beam L110 emitted by the first light emitter 110 and the laser beam L120 emitted by the second light emitter 120, and causes the laser beams L110 and laser beams L120 obtained by the division to exit the diffractive element 34. The diffractive element 34 is, for example, a simple diffraction grating that includes a large number of equally spaced parallel slits. The diffractive element 34 corresponds to a specific example of a "third optical member" of the present disclosure.

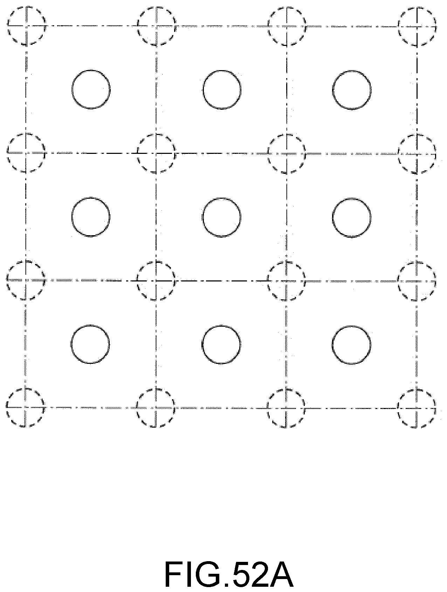

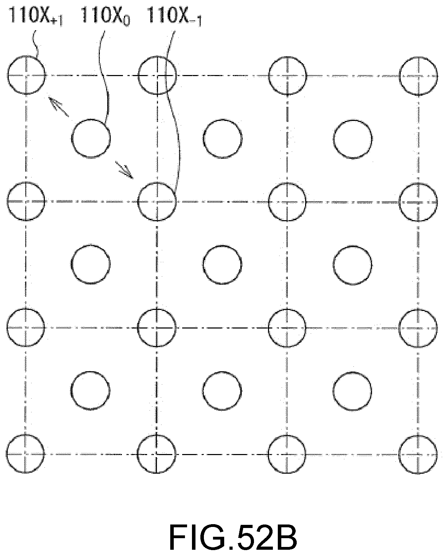

Fig. 52A illustrates an irradiation pattern of the laser beam L110 when the diffractive element 34 is not arranged, the laser beam L110 being emitted by the first light emitter 110 and used to perform spot irradiation onto the irradiation target 1000. Fig. 52A further illustrates an irradiation pattern of the laser beam L120 on which beam forming processing has not been performed. The irradiation pattern of the laser beam L110 is depicted using a solid line, and the irradiation pattern of the laser beam L120 is depicted using a dotted line. Fig. 52B illustrates the irradiation pattern of the laser beam L110 when the diffractive element 34 is arranged, the laser beam L110 being emitted by the first light emitter 110 and irradiated onto the irradiation target 1000.

As illustrated in Fig. 52B, the arrangement of the diffractive element 34 results in 0th order light (110X0) from among the laser beam L110 transmitted through the diffractive element 34 being irradiated in the form of a spot onto an irradiation portion onto which the laser beam L110 is to be irradiated when the diffractive element 34 is not arranged, and the arrangement of the diffractive element 34 results in + first order light (110X₊₁) and-first order light (110X₋₁) from among the laser beam L110 transmitted through the diffractive element 34 each being irradiated in the form of a spot onto an irradiation portion onto which the laser beam L120 on which beam forming processing has not been performed is to be irradiated. In other words, the arrangement of the diffractive element 34 makes it possible to further increase the number of spots of light irradiated onto the irradiation target 1000. Further, the laser beam L120 emitted by the second light emitter 120 and used to perform uniform irradiation is also diffracted as in the case of the laser beam L110 used to perform spot irradiation. Thus, an overlap of the pieces of diffracted light makes it possible to further improve the uniformity of intensity of light upon performing uniform irradiation.

As described above, the diffractive element 34 is further arranged in the light paths of the laser beams L110 and L120 respectively emitted by the first light emitter 110 and the second light emitter 120 in this modification. This makes it possible to perform spot irradiation and uniform irradiation onto the irradiation target 1000 with a higher degree of light density, compared to the embodiments and the like described above. In other words, a distance to an object situated farther away can be accurately measured upon performing spot irradiation. A distance to an object situated at a short distance can be measured at a higher resolution upon performing uniform irradiation.

Note that the example in which the diffractive element 14 and the diffractive element 34 are provided as separate parts has been described in this modification, but a diffractive optical surface may be arranged on each of two surfaces of an optical element. Further, the example in which the diffractive element 34 is arranged on the output side of the collimator lens 13 has been described in Fig. 51. However, a position at which the diffractive element 34 is arranged is not limited thereto, and, for example, the diffractive element 34 may be arranged between the microlens array 12 and the collimator lens 13.

Further, the example in which a simple diffraction grating is used as the diffractive element 34 has been described in this modification. However, for example, a diffractive optical element (DOE) that has a more complicated diffraction pattern may be used. Furthermore, the diffractive element 34 may be integrated with, for example, the microlens array 12. In this case, for example, the operation may be performed only with respect to the laser beam L110 used to perform spot irradiation or only with respect to the laser beam L120 used to perform uniform irradiation. Moreover, different diffraction patterns may be formed for the laser beam L110 used to perform spot irradiation and the laser beam L120 used to perform uniform irradiation.

### (2-5. Fifth Modification)

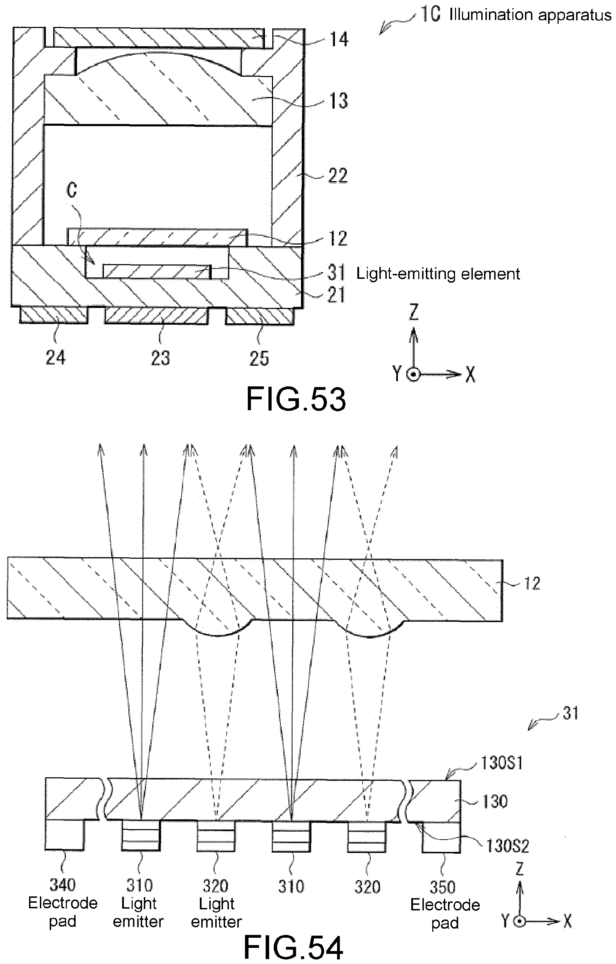

Fig. 53 is a cross-sectional view schematically illustrating an example of a schematic configuration of an illumination apparatus (an illumination apparatus 1C) according to a fifth modification of the present disclosure. The illumination apparatus 1C of this modification is different from the illumination apparatuses of the embodiments described above in using a back exit surface-emitting semiconductor laser as a light-emitting element 31.

Fig. 54 illustrates an example of a cross-sectional configuration of the light-emitting element 31 in the illumination apparatus 1C, and a positional relationship between the light-emitting element 31 and the microlens array 12. As described above, the light-emitting element 31 is a back exit vertical-cavity surface-emitting laser, and light emitters 310 and 320 of a plurality of light emitters 310 and 320 used to perform spot irradiation and uniform irradiation are formed in an array on the back surface (the surface 130S2) of the substrate 130. Further, an electrode pad 340 that applies voltage to the light emitter 310 and an electrode pad 350 that applies voltage to the light emitter 320 are further provided on the surface 130S2 of the substrate 130. Except for those points, the light-emitting element 31 has a configuration that is similar to the configuration of the light-emitting element 11.

As described above, not only a frontside-irradiation surface-emitting semiconductor laser, but also a backside-irradiation surface-emitting semiconductor laser may be used in the illumination apparatus according to the present disclosure. Using a backside-irradiation vertical-cavity surface-emitting laser as the light-emitting element 31 makes it possible to make a region for a plurality of electrode pads smaller. Further, switching between spot irradiation and uniform irradiation can be performed more easily, compared to the embodiments described above.

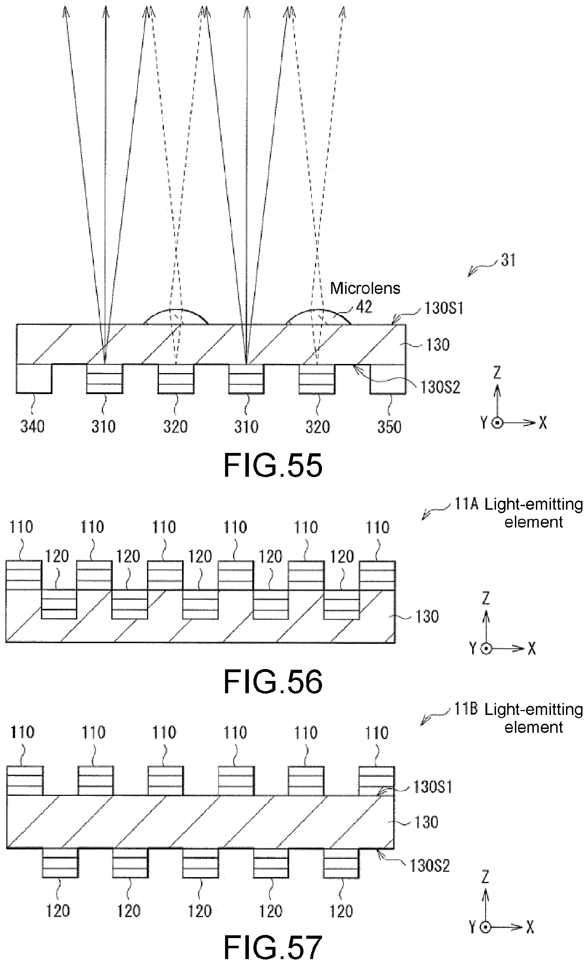

Further, when a back exit vertical-cavity surface-emitting laser is used as the light-emitting element 31, as in the case of this modification, the second optical member and the light-emitting element 31 may be formed to be integrated with each other. Specifically, for example, a microlens array 42 is arranged in, for example, a portion, on the front surface (the surface 130S1) of the substrate 130 of the light-emitting element 31, that faces a light emitter 320 of a plurality of light emitters 320 used to perform uniform irradiation, as illustrated in, for example, Fig. 55. This makes it possible to arrange the second optical member with a high degree of positional accuracy. Further, this makes it possible to reduce costs, compared to when an optical member such as the microlens array 42 is individually arranged.

Fig. 55 illustrates an example in which the microlens array 42 is arranged as the second optical member. Without being limited thereto, a diffractive optical element such as a Fresnel lens or a diffusion plate may be arranged.

### (2-6. Sixth Modification)

Fig. 56 schematically illustrates another example of a cross-sectional configuration of the light-emitting element 11 in a sixth modification of the present disclosure. The example in which the light-emitting element 11 including, in one plane, a plurality of first light emitters 110 used to perform spot irradiation and a plurality of second light emitters 120 used to perform uniform irradiation has been described in the embodiments above. However, the first light emitter 110 and the second light emitter 120 may be formed in different planes.

Specifically, the first light emitter 110 and the second light emitter 120 may be provided to the front surface (the surface 130S1) of the substrate 130 at different levels in directions of optical axes (for example, the Z-axis direction) corresponding to the laser beam L110 and laser beam L120 respectively emitted by the first light emitter 110 and the second light emitter 120, as in, for example, a light-emitting element 11A illustrated in Fig. 56.

Further, one of the first light emitter 110 and the second light emitter 120 (for example, the first light emitter 110) may be provided to the front surface (the surface 130S1) of the substrate 130, and another of the first light emitter 110 and the second light emitter 120 (for example, the second light emitter 120) may be provided to the back surface (the surface 130S2) of the substrate 130, as in, for example, a light-emitting element 11B illustrated in Fig. 57. In other words, from between the light portion used to perform spot irradiation and the light emitter used to perform uniform irradiation, a front exit vertical-cavity surface-emitting laser may be used as one of the light emitters, and a back exit vertical-cavity surface-emitting laser may be used as another of the light emitters.

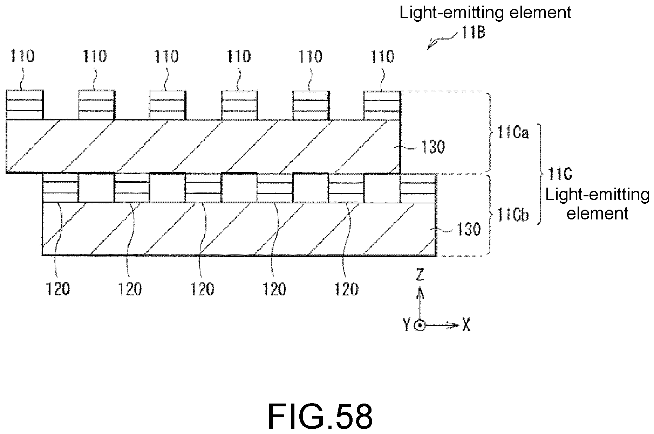

Furthermore, for example, a light-emitting element 11Ca that includes a plurality of first light emitters 110 used to perform spot irradiation, and a light-emitting element 11Cb that includes a plurality of second light emitters 120 used to perform uniform irradiation may be provided, and the light-emitting element 11Ca and the light-emitting element 11Cb may be used by being stacked, as in, for example, a light-emitting element 11C illustrated in Fig. 58.

When there is a difference in level between the first light emitter 110 and the second light emitter 120 in the light-emitting element 11, as described above, this makes it possible to further improve the uniformity of intensity of light upon performing uniform irradiation without separately arranging the diffractive element 34, as in the case of, for example, the fourth modification.

The present disclosure has been described above with reference to the embodiments and the first to sixth modifications. However, the present disclosure is not limited to the embodiments and the like described above, and various modification may be made thereto. For example, the first to sixth modifications described above may be combined, or, for example, a back exit vertical-cavity surface-emitting laser and the diffractive optical element 32 such as a Fresnel lens may be combined. Further, Figs. 44 and 49 each illustrate a DOE (the diffractive optical element 32) having a period greater than a wavelength. However, a structure smaller than a wavelength in size, that is, what is called a metamaterial may be used to provide a beam forming function. Further, the example in which the light-emitting element 11 according to the present disclosure includes two light emitter groups that are the first-light-emitter group 161 and the second-light-emitter group 162. However, the light-emitting element 11 can also include three or more light emitter groups.

Note that the effect described here is not necessarily limitative, and any of the effects described in the present disclosure may be provided.

Note that the present technology may also take the following configurations.
(1) An illumination apparatus, including:
   a light-emitting element that includes
      a plurality of first light emitters,
      a plurality of second light emitters,
      a lower electrode that is connected to the plurality of first light emitters and the plurality of second light emitters,
      a first upper electrode that is connected to each of the plurality of first light emitters, and
      a second upper electrode that is connected to each of the plurality of second light emitters; and
   a drive circuit that determines a first current that flows between the lower electrode and the first upper electrode, and a second current that flows between the lower electrode and the second upper electrode.
(2) The illumination apparatus according to (1), in which
   the drive circuit includes
   a first drive section that is electrically connected to the first upper electrodes and drives the plurality of first light emitters, and
   a second drive section that is electrically connected to the second upper electrodes and drives the plurality of second light emitters.
(3) The illumination apparatus according to (1), in which
   the drive circuit includes a drive section that is connected to the lower electrode and drives the plurality of first light emitters and the plurality of second light emitters.
(4) The illumination apparatus according to any one of (1) to (3), in which
   the light-emitting element includes
      a first-light-emitter group that includes a plurality of first-light-emitter columns each formed by first light emitters of the plurality of first light emitters being connected to each other using first wiring that is in contact with the first upper electrodes, and
      a second-light-emitter group that includes a plurality of second-light-emitter columns each formed by second light emitters of the plurality of second light emitters being connected to each other using second wiring that is in contact with the second upper electrodes,
   currents respectively flowing through first-light-emitter columns of the plurality of first-light-emitter columns flow in different directions, and
   currents respectively flowing through second-light-emitter columns of the plurality of second-light-emitter columns flow in different directions.
(5) The illumination apparatus according to (4), in which
   the first-light-emitter column and the second-light-emitter column are parallel to each other,
   the first-light-emitter column and the second-light-emitter column are arranged alternately,
   the first-light-emitter group includes a certain first-light-emitter column that is included in the plurality of first-light-emitter columns and through which a current flows in a first direction, and another first-light-emitter column that is included in the plurality of first-light-emitter columns and through which a current flows in a second direction that is a direction opposite to the first direction, the other first-light-emitter column being situated next to the certain first-light-emitter column in a state in which the second-light-emitter column is situated between the certain first-light-emitter column and the other first-light-emitter column, and
   the second-light-emitter group includes a certain second-light-emitter column that is included in the plurality of second-light-emitter columns and through which a current flows in the first direction, and another second-light-emitter column that is included in the plurality of second-light-emitter columns and through which a current flows in the second direction, the other second-light-emitter column being situated next to the certain second-light-emitter column in a state in which the first-light-emitter column is situated between the certain second-light-emitter column and the other second-light-emitter column.
(6) The illumination apparatus according to any one of (1) to (5), in which
   the plurality of first light emitters and the plurality of second light emitters are a vertical-cavity surface-emitting laser element.
(7) The illumination apparatus according to any one of (1) to (6), further including:
   a first optical member that forms a plurality of pieces of first light and a plurality of pieces of second light into pieces of substantially parallel light, and causes the pieces of substantially parallel light to exit the first optical member, the plurality of pieces of first light being a plurality of pieces of first light respectively emitted by first light emitters of the plurality of first light emitters, the plurality of pieces of second light being a plurality of pieces of second light respectively emitted by second light emitters of the plurality of second light emitters; and
   a second optical member that forms a beam shape of at least each of the plurality of pieces of first light or each of the plurality of pieces of second light, and causes the plurality of pieces of first light and the plurality of pieces of second light to exit the second optical member in a state in which a piece of first light of the plurality of pieces of first light and a piece of second light of the plurality of pieces of first light have different beam shapes.
(8) The illumination apparatus according to (7), in which
   the pieces of first light of the plurality of pieces of first light respectively emitted by the first light emitters of the plurality of first light emitters are irradiated onto an irradiation target in the form of respective spots, and
   the plurality of pieces of second light respectively emitted by the second light emitters of the plurality of second light emitters is substantially uniformly irradiated onto a specified range on the irradiation target in a state in which a portion of a certain piece of second light of the plurality of pieces of second lights overlaps a portion of another piece of second light of the plurality of pieces of second lights, the other piece of second light being emitted by the second light emitter adjacent to the second light emitter emitting the certain piece of second light.
(9) The illumination apparatus according to (7) or (8), in which
   the first light emitter of the plurality of first light emitters and the second light emitter of the plurality of second light emitters have different light-emitting areas.
(10)The illumination apparatus according to (7) or (8), in which
   the first light emitter of the plurality of first light emitters has a smaller area than the second light emitter of the plurality of second light emitters.
(11) The illumination apparatus according to any one of (7) to (10), in which
   the first optical member is a collimator lens.
(12) The illumination apparatus according to any one of (7) to (11), in which
   the second optical member is a microlens array.
(13) The illumination apparatus according to (12), in which
   the microlens array includes two types of lenses of different radiuses of curvature.
(14) The illumination apparatus according to any one of (7) to (11), in which
   the second optical member is a diffractive optical element.
(15) The illumination apparatus according to (14), in which
   the diffractive optical element is a Fresnel lens or a binary lens.
(16) The illumination apparatus according to any one of (8) to (15), further including
   a third optical member that is arranged in paths of the plurality of pieces of first light and the plurality of pieces of second light, the third optical member refracting or diffracting the plurality of pieces of first light to increase the number of spots irradiated on the irradiation target, the third optical member refracting or diffracting the plurality of pieces of second light to increase a range in which a certain piece of second light of the plurality of pieces of second lights overlaps another piece of second light of the plurality of pieces of second lights, the other piece of second light being emitted by the second light emitter adjacent to the second light emitter emitting the certain piece of second light.
(17) An illumination apparatus, including:
   a light-emitting element that includes
      a plurality of first light emitters,
      a plurality of second light emitters,
      a lower electrode that is connected to the plurality of first light emitters and the plurality of second light emitters,
      a first upper electrode that is connected to each of the plurality of first light emitters, and
      a second upper electrode that is connected to each of the plurality of second light emitters;
   a drive circuit that determines a first current that flows between the lower electrode and the first upper electrode, and a second current that flows between the lower electrode and the second upper electrode;
   a first optical member that forms a plurality of pieces of first light and a plurality of pieces of second light into pieces of substantially parallel light, and causes the pieces of substantially parallel light to exit the first optical member, the plurality of pieces of first light being a plurality of pieces of first light respectively emitted by first light emitters of the plurality of first light emitters, the plurality of pieces of second light being a plurality of pieces of second light respectively emitted by second light emitters of the plurality of second light emitters; and
   a second optical member that forms a beam shape of each of the plurality of pieces of second light, and causes the plurality of pieces of second light to exit the second optical member.
(18) A ranging apparatus, including:
   an illumination apparatus that emits light to an object;
   a light-receiving section that detects reception of light reflected off the object; and
   a ranging section that measures a distance to the object,
   the illumination apparatus including a light-emitting element and a drive circuit,
   the light-emitting element including
      a plurality of first light emitters,
      a plurality of second light emitters,
      a lower electrode that is connected to the plurality of first light emitters and the plurality of second light emitters,
      a first upper electrode that is connected to each of the plurality of first light emitters, and
      a second upper electrode that is connected to each of the plurality of second light emitters,
   the drive circuit determining a first current that flows between the lower electrode and the first upper electrode, and a second current that flows between the lower electrode and the second upper electrode. Reference Signs List

- 1: illumination apparatus
- 11: light-emitting element
- 12: microlens array
- 13: collimator lens
- 14: diffractive element
- 16: contact layer
- 17: mesa portion
- 100: ranging apparatus
- 110: first light emitter
- 120: second light emitter
- 130: substrate
- 140: semiconductor layer
- 151: upper electrode
- 151A: first upper electrode
- 151B: second upper electrode
- 152: lower electrode
- 161: first-light-emitter group
- 162: second-light-emitter group
- 210: light-receiving section
- 220: controller
- 230: ranging section
- 260, 263, 264, 265, 266, 267: drive section

## Claims

1. An illumination apparatus, comprising:
a light-emitting element that includes
a plurality of first light emitters,
a plurality of second light emitters,
a lower electrode that is connected to the plurality of first light emitters and the plurality of second light emitters,
a first upper electrode that is connected to each of the plurality of first light emitters, and
a second upper electrode that is connected to each of the plurality of second light emitters; and
a drive circuit that determines a first current that flows between the lower electrode and the first upper electrode, and a second current that flows between the lower electrode and the second upper electrode.

2. The illumination apparatus according to claim 1, wherein
the drive circuit includes
a first drive section that is electrically connected to the first upper electrodes and drives the plurality of first light emitters, and
a second drive section that is electrically connected to the second upper electrodes and drives the plurality of second light emitters.

3. The illumination apparatus according to claim 1, wherein
the drive circuit includes a drive section that is connected to the lower electrode and drives the plurality of first light emitters and the plurality of second light emitters.

4. The illumination apparatus according to claim 1, wherein
the light-emitting element includes
a first-light-emitter group that includes a plurality of first-light-emitter columns each formed by first light emitters of the plurality of first light emitters being connected to each other using first wiring that is in contact with the first upper electrodes, and
a second-light-emitter group that includes a plurality of second-light-emitter columns each formed by second light emitters of the plurality of second light emitters being connected to each other using second wiring that is in contact with the second upper electrodes,
currents respectively flowing through first-light-emitter columns of the plurality of first-light-emitter columns flow in different directions, and
currents respectively flowing through second-light-emitter columns of the plurality of second-light-emitter columns flow in different directions.

5. The illumination apparatus according to claim 4, wherein
the first-light-emitter column and the second-light-emitter column are parallel to each other,
the first-light-emitter column and the second-light-emitter column are arranged alternately,
the first-light-emitter group includes a certain first-light-emitter column that is included in the plurality of first-light-emitter columns and through which a current flows in a first direction, and another first-light-emitter column that is included in the plurality of first-light-emitter columns and through which a current flows in a second direction that is a direction opposite to the first direction, the other first-light-emitter column being situated next to the certain first-light-emitter column in a state in which the second-light-emitter column is situated between the certain first-light-emitter column and the other first-light-emitter column, and
the second-light-emitter group includes a certain second-light-emitter column that is included in the plurality of second-light-emitter columns and through which a current flows in the first direction, and another second-light-emitter column that is included in the plurality of second-light-emitter columns and through which a current flows in the second direction, the other second-light-emitter column being situated next to the certain second-light-emitter column in a state in which the first-light-emitter column is situated between the certain second-light-emitter column and the other second-light-emitter column.

6. The illumination apparatus according to claim 1, wherein
the plurality of first light emitters and the plurality of second light emitters are a vertical-cavity surface-emitting laser element.

7. The illumination apparatus according to claim 1, further comprising:
a first optical member that forms a plurality of pieces of first light and a plurality of pieces of second light into pieces of substantially parallel light, and causes the pieces of substantially parallel light to exit the first optical member, the plurality of pieces of first light being a plurality of pieces of first light respectively emitted by first light emitters of the plurality of first light emitters, the plurality of pieces of second light being a plurality of pieces of second light respectively emitted by second light emitters of the plurality of second light emitters; and
a second optical member that forms a beam shape of at least each of the plurality of pieces of first light or each of the plurality of pieces of second light, and causes the plurality of pieces of first light and the plurality of pieces of second light to exit the second optical member in a state in which a piece of first light of the plurality of pieces of first light and a piece of second light of the plurality of pieces of first light have different beam shapes.

8. The illumination apparatus according to claim 7, wherein
the pieces of first light of the plurality of pieces of first light respectively emitted by the first light emitters of the plurality of first light emitters are irradiated onto an irradiation target in the form of respective spots, and
the plurality of pieces of second light respectively emitted by the second light emitters of the plurality of second light emitters is substantially uniformly irradiated onto a specified range on the irradiation target in a state in which a portion of a certain piece of second light of the plurality of pieces of second lights overlaps a portion of another piece of second light of the plurality of pieces of second lights, the other piece of second light being emitted by the second light emitter adjacent to the second light emitter emitting the certain piece of second light.

9. The illumination apparatus according to claim 7, wherein
the first light emitter of the plurality of first light emitters and the second light emitter of the plurality of second light emitters have different light-emitting areas.

10. The illumination apparatus according to claim 7, wherein
the first light emitter of the plurality of first light emitters has a smaller area than the second light emitter of the plurality of second light emitters.

11. The illumination apparatus according to claim 7, wherein
the first optical member is a collimator lens.

12. The illumination apparatus according to claim 7, wherein
the second optical member is a microlens array.

13. The illumination apparatus according to claim 12, wherein
the microlens array includes two types of lenses of different radiuses of curvature.

14. The illumination apparatus according to claim 7, wherein
the second optical member is a diffractive optical element.

15. The illumination apparatus according to claim 14, wherein
the diffractive optical element is a Fresnel lens or a binary lens.

16. The illumination apparatus according to claim 8, further comprising
a third optical member that is arranged in paths of the plurality of pieces of first light and the plurality of pieces of second light, the third optical member refracting or diffracting the plurality of pieces of first light to increase the number of spots irradiated on the irradiation target, the third optical member refracting or diffracting the plurality of pieces of second light to increase a range in which a certain piece of second light of the plurality of pieces of second lights overlaps another piece of second light of the plurality of pieces of second lights, the other piece of second light being emitted by the second light emitter adjacent to the second light emitter emitting the certain piece of second light.

17. An illumination apparatus, comprising:
a light-emitting element that includes
a plurality of first light emitters,
a plurality of second light emitters,
a lower electrode that is connected to the plurality of first light emitters and the plurality of second light emitters,
a first upper electrode that is connected to each of the plurality of first light emitters, and
a second upper electrode that is connected to each of the plurality of second light emitters;
a drive circuit that determines a first current that flows between the lower electrode and the first upper electrode, and a second current that flows between the lower electrode and the second upper electrode;
a first optical member that forms a plurality of pieces of first light and a plurality of pieces of second light into pieces of substantially parallel light, and causes the pieces of substantially parallel light to exit the first optical member, the plurality of pieces of first light being a plurality of pieces of first light respectively emitted by first light emitters of the plurality of first light emitters, the plurality of pieces of second light being a plurality of pieces of second light respectively emitted by second light emitters of the plurality of second light emitters; and
a second optical member that forms a beam shape of each of the plurality of pieces of second light, and causes the plurality of pieces of second light to exit the second optical member.

18. A ranging apparatus, comprising:
an illumination apparatus that emits light to an object;
a light-receiving section that detects reception of light reflected off the object; and
a ranging section that measures a distance to the object,
the illumination apparatus including a light-emitting element and a drive circuit,
the light-emitting element including
a plurality of first light emitters,
a plurality of second light emitters,
a lower electrode that is connected to the plurality of first light emitters and the plurality of second light emitters,
a first upper electrode that is connected to each of the plurality of first light emitters, and
a second upper electrode that is connected to each of the plurality of second light emitters,
the drive circuit determining a first current that flows between the lower electrode and the first upper electrode, and a second current that flows between the lower electrode and the second upper electrode.
